# EUROPEAN PATENT APPLICATION

(11) **EP 0 840 381 A2**
(43) Date of publication of application: **06.05.1998**
(21) Application number: 97118825.5
(22) Date of filing: 29.10.1997
(51) Int. Cl.: H01L 31/18, H01L 31/20, H01L 31/0392, H01L 27/142

(54) **Thin-film semiconductor device and its manufacturing method and apparatus and thin-film semiconductor solar cell module and its manufacturing method**

(30) Priority: 31.10.1996 JP 290501/96; 31.10.1996 JP 290502/96; 19.11.1996 JP 308533/96; 03.07.1997 JP 178199/97
(71) Applicant: SONY CORPORATION, Tokyo (JP)
(72) Inventor: Matsushita, Takeshi, Shinagawa-ku, Tokyo (JP); Nakagoe, Miyako, Shinagawa-ku, Tokyo (JP); Westwater, Jonathan, Shinagawa-ku, Tokyo (JP); Kusunoki, Misao, Shinagawa-ku, Tokyo (JP); Yamauchi, Kazushi, Shinagawa-ku, Tokyo (JP)
(74) Representative: Müller, Frithjof E., Dipl.-Ing.

(57) **Abstract**

A method for manufacturing a thin-film semiconductor device configured to form the thin-film semiconductor device on a first substrate and thereafter transfer the thin-film semiconductor device from the first substrate to a second substrate, comprises the steps of: forming a porous layer containing a separation layer on the first substrate; forming the thin-film semiconductor device on the porous layer; and after bonding the second substrate different from the first substrate in contraction coefficient by cooling onto the thin-film semiconductor device, cooling the product by cooling means to produce a shear stress in the separation layer in the porous layer and to separate the thin-film semiconductor device from the first substrate along the separation layer.

Another method for manufacturing a thin-film semiconductor device comprises the steps of: forming a porous layer containing a separation layer on the first substrate; forming the thin-film semiconductor device on the porous layer; and after bonding the second substrate onto the thin-film semiconductor device, irradiating an ultrasonic wave to separate the thin-film semiconductor device from the first substrate along the separation layer.

## Description

### BACKGROUND OF THE INVENTION

### Field of the Invention

This invention relates to a thin-film semiconductor device such as solar cell made by first making a semiconductor device on a substrate and then transferring it onto another substrate. The invention also relates to a method and an apparatus for manufacturing such thin-film semiconductor devices, a thin-film semiconductor solar cell module, and its manufacturing method.

### Description of the Related Art

Solar cells have recently been brought into practice but still in limited uses. For full-scale use of solar cells, it is especially important to realize resource saving and cost reduction. Accounting the issues of energy conversion efficiency (photoelectric conversion) and energy pay-back period, thin-film solar cells are preferable to thick film solar cells. Since thin-film solar cells have a certain flexibility and can be mounted on curved portions of vehicle bodies or curved outer surfaces of portable electric appliances for electricity generation, they are available for wider uses.

To facilitate fabrication of such thin-film solar cells, The Applicant previously proposed a method for separating a device-making layer from a substrate (U.S. Ser. No. 595382) and a method for manufacturing a thin-film semiconductor, solar cell and light emitting device (Japanese Patent Application No. 8-234480).

The method disclosed in U.S. Ser. No. 595382 uses a crystal substrate (single-crystal silicon substrate) as the substrate, forms a porous layer as a separation layer, then grows on the porous layer a semiconductor layer forming a solar cell, bonds a plastic plate on the semiconductor layer by an adhesive, and then applies a tensile stress to separate the semiconductor layer together with the plastic plate from the crystal substrate. In this method, the crystal substrate can be used repeatedly, and therefore contributes to resource saving and cost reduction.

The method disclosed in Japanese Patent Application No. 8-234480 is an improvement of the former method, in which the porous layer as the separation layer varies in porosity in its thickness direction to weaken the tensile strength of the separation layer, and the quality of the semiconductor layer on the porous layer is improved. Especially, anodic oxidation current varying from 1 mA/cm² through 7 mA/cm² to 200 mA/cm² is applied to a silicon substrate to form a porous silicon layer used as the separation layer, and the semiconductor device layer is formed on the porous silicon layer by epitaxial growth. This method can make a separation layer having a weak tensile strength within the porous silicon layer.

This method, however, involves the following problems. When the tensile strength of the separation layer is too weak, the semiconductor device layer separates partly or entirely from the substrate during formation of an oxide film, for example, in a process for fabricating a solar cell or other semiconductor device in the semiconductor layer, due to a stress caused by a difference in expansion coefficient between the oxide film and silicon. Moreover, if the semiconductor device is exposed to a vacuum while a vapor deposition film, for example, is made, then the device layer may partly strips away from the substrate due to a stress caused by a difference in air pressure between pours in the porous silicon layer and the vacuum on the device surface. Especially when the substrate is a silicon substrate, which is liable to cleave and liable to break down with a weak stress, the problem often occurs during application of a tensile stress. In contrast, when the tensile strength of the separation layer is too large, the problem of separation does not occur in the process of forming the semiconductor device. However, the tensile strength in the separation layer increases when the tensile stress is applied. This results in separation between the plastic plate and the adhesive or between the semiconductor device and the adhesive, and makes it very difficult to separate the semiconductor device as a reliable product from the substrate.

As reviewed above, it is difficult for the formerly proposed methods of manufacturing a thin-film semiconductor device to make an separation layer having an appropriate tensile strength satisfying both the requirement that the semiconductor device never separates from the substrate during the manufacturing process and the requirement that the semiconductor device, maintaining a high quality, can be readily separated from the substrate when it is transferred to another substrate. Especially for manufacturing a semiconductor device, such as solar cell or LSI (Large Scale Integrated circuit), having a large area, the issue of the tensile force of the separation layer is one of most serious problems to be overcome.

As to the requirement of cost reduction of solar cells, cost reduction is necessary not only for individual solar cells themselves but also for a module containing a plurality of solar cells connected in series and in parallel. However, since single-crystal or polycrystalline silicon solar cells conventionally used for electricity generation use a silicon wafer having the thickness of approximately 300 µm, individual silicon wafers supporting solar cells must be connected electrically for incorporating them into a module, and the cost of the module remains high. Therefore, there is a demand for solar cells in form of a monolithic device.

For applications of solar cells to various portable appliances, such as wrist watches or portable electric calculators, miniaturization, cost reduction and high flexibility in design choice of appliances are required, and here again is a demand for a monolithic device of solar cells. Amorphous silicon solar cells can be made in form of a monolithic device on a substrate made of amorphous silicon. In this respect, amorphous silicon is an excellent material of solar cells. However, the photoelectric conversion efficiency of amorphous silicon is low, and the use of amorphous silicon solar cells is limited to applications to portable electric calculators, or the like.

If it is possible to realize a monolithic device of solar cells using single-crystal silicon having a higher photoelectric conversion efficiency than that of amorphous silicon, the cost of solar cells will be reduced, and they will be used in more applications. Japanese Patent Laid-Open Publication No. 54-6791 discloses a monolithic device of solar cells using a thick single-crystal silicon film. However, due to the thickness, it involves various problems, such as high cost, long energy pay-back period, less flexibility, and so on.

For mounting solar cells in portions thorough which light must pass through, such as house windows, vehicle windows, sun roofs, etc., for electricity generation, the solar cells must be see-through.

Amorphous silicon solar cells permit part of incident light to pass through. Therefore, see-through solar cells, in which a number of fine holes are made in a uniform distribution in an amorphous silicon film to form the solar cells, are being manufactured. However, amorphous silicon solar cello originally have a low photoelectric conversion efficiency, and making a number of fine holes results in an unacceptable decrease in generated output.

If solar cells using single-crystal or polycrystalline silicon higher in conversion efficiency than amorphous silicon can be readily made in a see-through form, then the use of solar cells in house windows, or the like, will be increased drastically. However, it is very difficult to make a number of fine holes in currently available single-crystal or polycrystalline silicon solar cells having the thickness of approximately 300 µm.

### OBJECTS AND SUMMARY OF THE INVENTION

It is therefore an object of the invention to provide a method and an apparatus for manufacturing a thin-film semiconductor device, capable of readily separating and transferring a thin-film semiconductor device from a substrate to another substrate, free from the problem of separation during the semiconductor device being made, and suitable also for manufacturing a thin-film semiconductor device with a large area.

Another object of the invention is to provide a thin-film semiconductor device manufactured by the above-mentioned method, therefore improved in quality, and capable of being made as a large-scaled device.

Another object of the invention is to provide a monolithic thin-film single-crystal semiconductor solar cell and its manufacturing method, which enables cost reduction, flexibility, miniaturization, flexibility in design choice of appliances using solar cells, and extension over a wide area.

Another object of the invention is to provide a thin-film single-crystal semiconductor solar cell and its manufacturing method, which is see-through but exhibits a high conversion efficiency.

According to the invention there is provided a method for manufacturing a thin-film semiconductor device configured to form the thin-film semiconductor device on a first substrate and thereafter transfer the thin-film semiconductor device from the first substrate to a second substrate, comprising the steps of:
forming a porous layer containing a separation layer on the first substrate;
forming the thin-film semiconductor device on the porous layer; and
after bonding the second substrate different from the first substrate in contraction coefficient by cooling onto the thin-film semiconductor device, cooling the product by cooling means to produce a shear stress in the separation layer in the porous layer and to separate the thin-film semiconductor device from the first substrate along the separation layer.

According to another aspect of the invention, there is provided a method for manufacturing a thin-film semiconductor device configured to first form the thin-film semiconductor device on a first substrate and thereafter transfer the thin-film semiconductor device from the first substrate to a second substrate, comprising the steps of:
forming a porous layer containing a separation layer on the first substrate;
forming the thin-film semiconductor device on the porous layer; and
after bonding the second substrate onto the thin-film semiconductor device, irradiating an ultrasonic wave to separate the thin-film semiconductor device from the first substrate along the separation layer.

According to another aspect of the invention, there is provided a method for manufacturing a thin-film semiconductor device configured to first form the thin-film semiconductor device on a first substrate and thereafter transfer the thin-film semiconductor device from the first substrate to a second substrate, comprising the steps of:
forming a porous layer containing a separation layer on the first substrate;
forming the thin-film semiconductor device on the porous layer; and
after bonding the second substrate onto the thin-film semiconductor device, applying a centrifugal force to separate the thin-film semiconductor device from the first substrate along the separation layer.

The above, and other, objects, features and advantage of the present invention will become readily apparent from the following detailed description thereof which is to be read in connection with the accompanying drawings.

### BRIEF DESCRIPTION OF THE DRAWINGS

Figs. 1A through 1D are cross-sectional views of a thin-film semiconductor device in different steps of a manufacturing process according to the first embodiment of the invention;
Figs. 2A and 2B are cross-sectional views of the thin-film semiconductor device in steps subsequent to those of Figs. 1A through 1D;
Figs. 3A and 3B are cross-sectional views of the thin-film semiconductor device in steps subsequent to those of Figs. 2A and 2B;
Fig. 4 is a cross-sectional view illustrating a construction of a cooling device used in steps shown in Figs. 2A through 3B;
Fig. 5 is a cross-sectional view illustrating a construction of another cooling device;
Figs. 6A and 6B are cross-sectional views of a thin-film semiconductor device in different steps of a manufacturing process according to the second embodiment of the invention;
Fig. 7 is a diagram of a construction for explaining ultrasonic irradiation;
Figs. 8A and 8B are cross-sectional views of a thin-film semiconductor device in different steps of a manufacturing process according to the third embodiment of the invention;
Fig. 9A is a plan view of a centrifugal separator used in the step shown in Fig. 8B, and Fig. 9B is a cross-sectional view taken along the A-A line of Fig. 9A;
Fig. 10 is a cross-sectional view illustrating a construction of a transfer holder in the centrifugal separator shown in Figs. 9A and 9B;
Fig. 11 is a cross-sectional view illustrating another construction of the transfer holder;
Fig. 12 is a cross-sectional view for explaining a method for manufacturing thin-film single-crystal silicon solar cells according to the fourth embodiment of the invention;
Fig. 13 is a cross-sectional view for explaining the method for manufacturing the thin-film single-crystal silicon solar cells according to the fourth embodiment of the invention;
Fig. 14 is a cross-sectional view for explaining the method for manufacturing the thin-film single-crystal silicon solar cells according to the fourth embodiment of the invention;
Fig. 15 is a cross-sectional view for explaining the method for manufacturing the thin-film single-crystal silicon solar cells according to the fourth embodiment of the invention;
Fig. 16 is a cross-sectional view for explaining the method for manufacturing the thin-film single-crystal silicon solar cells according to the fourth embodiment of the invention;
Fig. 17 is a cross-sectional view for explaining the method for manufacturing the thin-film single-crystal silicon solar cells according to the fourth embodiment of the invention;
Fig. 18 is a cross-sectional view for explaining the method for manufacturing the thin-film single-crystal silicon solar cells according to the fourth embodiment of the invention;
Fig. 19 is a cross-sectional view for explaining the method for manufacturing the thin-film single-crystal silicon solar cells according to the fourth embodiment of the invention;
Fig. 20 is a cross-sectional view for explaining the method for manufacturing the thin-film single-crystal silicon solar cells according to the fourth embodiment of the invention;
Fig. 21 is a cross-sectional view for explaining the method for manufacturing the thin-film single-crystal silicon solar cells according to the fourth embodiment of the invention;
Fig. 22 is a cross-sectional view for explaining the method for manufacturing the thin-film single-crystal silicon solar cells according to the fourth embodiment of the invention;
Fig. 23 is a cross-sectional view for explaining the method for manufacturing the thin-film single-crystal silicon solar cells according to the fourth embodiment of the invention;
Fig. 24 is a cross-sectional view for explaining the method for manufacturing the thin-film single-crystal silicon solar cells according to the fourth embodiment of the invention;
Fig. 25 is a cross-sectional view for explaining the method for manufacturing the thin-film single-crystal silicon solar cells according to the fourth embodiment of the invention;
Fig. 26 is a plan view showing a plan=view configuration of the thin-film single-crystal silicon solar cells according to the fourth embodiment of the invention;
Fig. 27 is a plan view showing another plan-view configuration of the thin-film single-crystal silicon solar cells according to the fourth embodiment of the invention;
Fig. 28 is a cross-sectional view for explaining a method for manufacturing a thin-film single-crystal silicon solar cell according to a fifth embodiment of the invention;
Fig. 29 is a cross-sectional view for explaining a method for manufacturing a thin-film single-crystal silicon solar cell according to a seventh embodiment of the invention;
Fig. 30 is a cross-sectional view for explaining a method for manufacturing a thin-film single-crystal silicon solar cell according to an eighth embodiment of the invention;
Fig. 31 is a cross-sectional view for explaining the method for manufacturing the thin-film single-crystal silicon solar cell according to the eighth embodiment of the invention;
Fig. 32 is a cross-sectional view for explaining the method for manufacturing the thin-film single-crystal silicon solar cell according to the eighth embodiment of the invention;
Fig. 33 is a cross-sectional view for explaining the method for manufacturing the thin-film single-crystal silicon solar cell according to the eighth embodiment of the invention;
Fig. 34 is a cross-sectional view for explaining the method for manufacturing the thin-film single-crystal silicon solar cell according to the eighth embodiment of the invention;
Fig. 35 is a cross-sectional view for explaining the method for manufacturing the thin-film single-crystal silicon solar cell according to the eighth embodiment of the invention;
Fig. 36 is a cross-sectional view for explaining the method for manufacturing the thin-film single-crystal silicon solar cell according to the eighth embodiment of the invention;
Fig. 37 is a cross-sectional view for explaining the method for manufacturing the thin-film single-crystal silicon solar cell according to the eighth embodiment of the invention;
Fig. 38 is a cross-sectional view for explaining the method for manufacturing the thin-film single-crystal silicon solar cell according to the eighth embodiment of the invention;
Fig. 39 is a cross-sectional view for explaining the method for manufacturing the thin-film single-crystal silicon solar cell according to the eighth embodiment of the invention;
Fig. 40 is a cross-sectional view for explaining the method for manufacturing the thin-film single-crystal silicon solar cell according to the eighth embodiment of the invention;
Fig. 41 is a plan view showing a plan-view configuration of the thin-film single-crystal silicon solar cell according to the eighth embodiment of the invention; and
Fig. 42 is a cross-sectional view for explaining a method for manufacturing a thin-film single-crystal silicon solar cell according to a ninth embodiment of the invention.

### DETAILED DESCRIPTION OF THE PREFERRED EMBODIMENTS

Embodiments of the invention are explained below in detail with reference to the drawings.

### (First Embodiment)

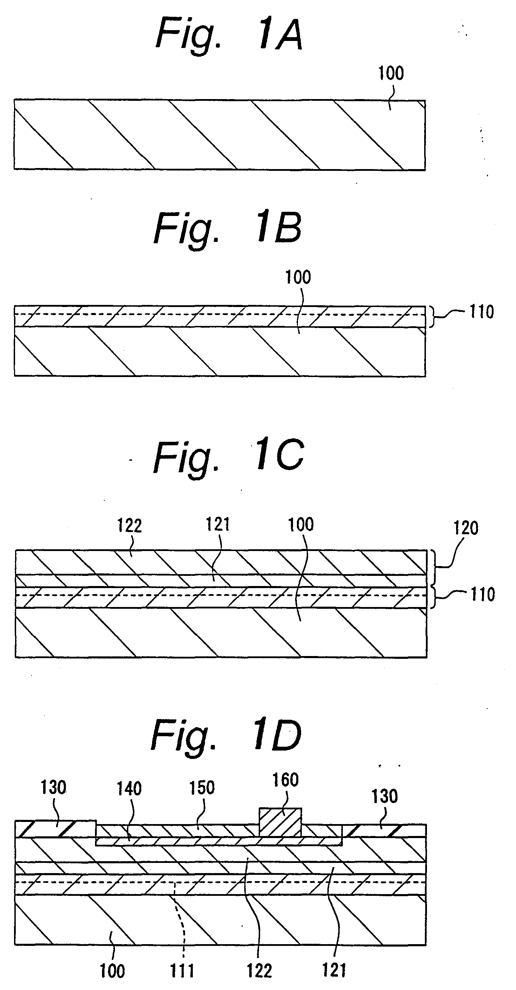

Figs. 1A through 3B are cross-sectional views of a thin-film semiconductor device in different steps of a manufacturing process according to an embodiment of the invention. The thin-film semiconductor device taken here is a thin-film single-crystal silicon solar cell.

First prepared as a first substrate is a single-crystal silicon substrate (p-type, 0.01 to 0.02 Ω·cm) 100 (hereinafter referred to as silicon substrate 100), for example, as shown in Fig. 1A. Formed on the silicon substrate 100 is a porous silicon layer 110 by anodic oxidation, for example, as shown in Fig. 1B. Anodic oxidation pertains to a method relying on electric conduction in a water solution of hydrofluoric acid, using the silicon substrate 100 as the anode, and it can be conducted by a double-cell method proposed by Ito, et al. in "Anodic Oxidation of Porous Silicon" (Surface Technologies, Vol. 46, No. 5, pp 8-13, 1995). In this method, a silicon substrate to form a porous layer thereon is disposed between two electrolytic solution tanks, and platinum electrodes connected to a d.c. source are set in both electrolytic solution tanks. Then, electrolytic solutions are poured into both electrolytic solution tanks, and a d.c. voltage is applied to the platinum electrodes, to use the silicon substrate as the anode and the platinum electrode as the cathode. Thus, one of opposite surfaces of the silicon substrate is corroded to become porous.

In this embodiment, using anodic oxidation, a porous silicon layer having a separation layer whose tensile strength is weak is made on the single-crystal silicon substrate, and a solar cell is formed on the porous silicon layer. Then, the solar cell is separated from the separation layer in the porous silicon layer, using a cooling means explained later, and transferred onto another substrate.

More specifically, using an electrolytic solution containing HF (hydrogen fluoride) : C₂H₅OH (ethanol) = 1:1, for example, as an electrolytic solution (anodic oxidation solution), first-step anodic oxidation is executed for 8 minutes under the current density of approximately 0.5 to 3 mA/cm², for example, to form a first porous silicon layer with a small porosity. After that, second-step anodic oxidation is effected for 8 minutes under the current density of approximately 3 to 30 mA/cm², for example, to form a second porous silicon layer with an intermediate porosity. Further executed third-step anodic oxidation for several second under the current density of approximately 40 to 300 mA/cm², for example, to form a third porous silicon layer with a large porosity. When the third porous silicon layer (porous silicon layer 110) is being formed, a layer with a very large porosity as the origin of the separation layer 111 (Fig. 1D), explained later, is also formed in the porous silicon layer 110. The silicon substrate 100 is preferably a p-type single crystal from the viewpoint of forming the porous silicon layer 110 thereon by anodic oxidation. However, n-type single crystal or polycrystalline silicon are usable under appropriate conditions.

Next formed is a solar cell on the porous silicon layer 110. That is, first executed is hydrogen annealing for 30 minutes at the temperature of 1100°C, for example, to cover holes opening to the surface of the porous silicon layer 110. Thereafter, as shown in Fig. 1C, an epitaxial layer 120 is made as a semiconductor device film on the porous silicon layer 110 by epitaxial growth using gas of SiH₄ or other appropriate material at the temperature of 1070°C, for example. The thickness of the epitaxial layer 120 is 1 to 50 µm, for example, when a single-crystal silicon solar cell is to be made. In order to increase the efficiency of the solar cell, first grown as the epitaxial layer 120 is a p⁺-type layer 121 with the high concentration of 10¹⁹/cm³, for example, up to the thickness of approximately 1 µm, and a p-type layer 122 with a concentration from 10¹⁵ to 10¹⁸/cm³ is grown on the p⁺-type layer 121 up to the thickness of 1 to 49 µm. In this structure, electrons generated by light in the p-type layer are reflected by the p⁺-type layer 121, which results in less recombination in the p⁺-type layer 121, and the solar cell is made highly efficient.

After that, as shown in Fig. 1D, an oxide film 130 is formed on the epitaxial layer 120 by thermal oxidation, for example, and then patterned. Using the patterned oxide film 130 as a mask, an -type impurity is doped into the p-type layer 122 to form a high-concentrated n⁺-type layer 140 which will behave as a the cathode of the solar cell. Further formed on the n⁺-type layer 140 is a non-reflective film 150, and an electrode aperture is formed in the non-reflective film 150. Then, a metal electrode 160 made of aluminum (Al), for example, is selectively formed in the aperture. During the above-mentioned hydrogen annealing and epitaxial growth, silicon atoms in the porous silicon layer 110 move and recombine. As a result, a portion of the porous silicon layer 110 heretofore having a large porosity again changes largely and becomes a layer with the smallest tensile force, namely, the separation layer 111. However, the separation layer 111 has a tensile strength large enough to prevent partial or entire separation of the epitaxial layer 120 from the silicon substrate 100 during formation of the solar cell in the epitaxial layer 120.

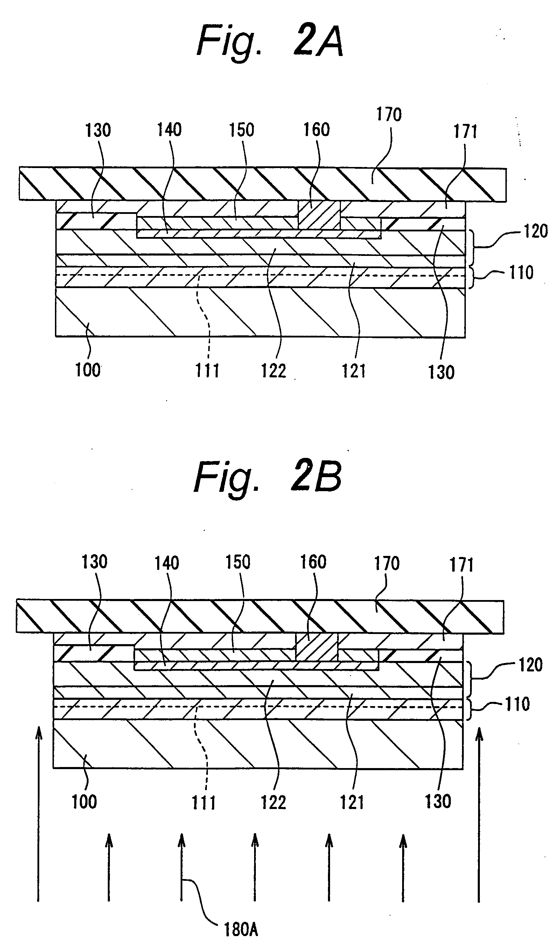

After the metal electrode 160 is formed, as shown in Fig. 2A, a plastic plate 170 made of PET (polyethylene terephthalate), for example, as the second substrate, is bonded to the surface of the silicon substrate 100 (oxide film 130), using an adhesive 171 (for example, ultraviolet setting adhesive) 171 strong against a tensile force.

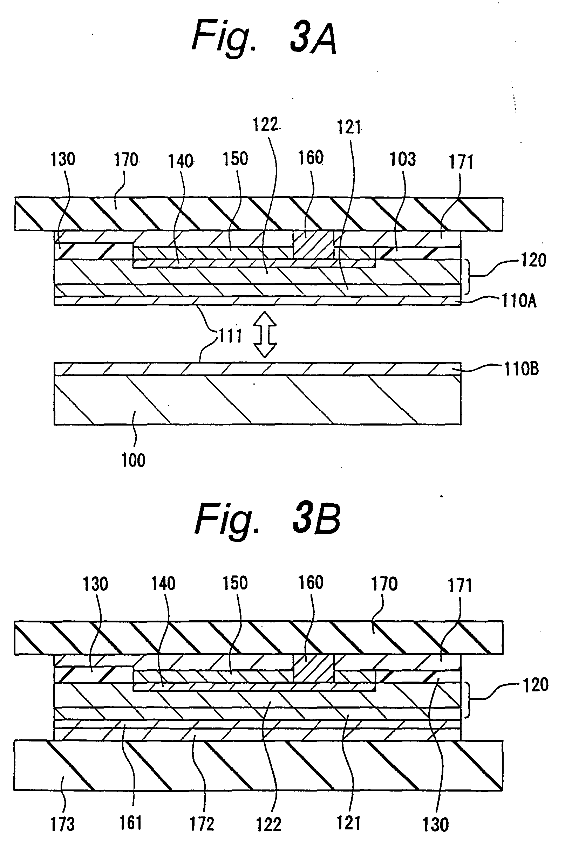

In the next step of the embodiment, the solar cell formed in the epitaxial layer 120 and the plastic plate 170 thereon are separated from the silicon substrate 100, using a cooling means. That is, as shown in Fig. 2B, the silicon substrate 100 and the plastic plate 170 are cooled by vapor 180A of liquid nitrogen, for example. The silicon substrate 100 and the plastic plate 170 exhibit different contraction coefficients when cooled. In general, the contraction coefficient of the plastic plate 170 is much larger than that of the silicon substrate 100. Therefore, although the silicon substrate 100 contracts when cooled by the liquid nitrogen vapor 180A, the plastic plate 170 contracts with a larger rate than the silicon substrate 100. Due to the difference in contraction coefficient, a large shear stress occurs in the separation layer 111. As a result, the semi-product solar cell (epitaxial layer 120 and plastic plate 170) separates from the silicon substrate 100 along the separation layer 111 as shown in fig. 3A. That is, the solar cell is transferred from the silicon substrate 100 to the plastic plate 170.

After that, the porous silicon layer 110A remaining on the epitaxial layer 120 is removed by etching. Then, as shown in Fig. 3B, a bottom electrode 161 is formed on the bottom surface of the epitaxial layer 120 by printing, for example. After that, another plastic plate 173 made of PET or PC (polycarbonate), for example, is bonded to the bottom electrode 161 using the adhesive 172. As a result, a thin-film single-crystal silicon solar cell sandwiched by two plastic plates 170 and 173 is completed. The silicon substrate 100 after separation of the solar cell can be re-used by removing the remainder porous silicon layer 110B on the surface by etching.

As explained above, according to the embodiment, by using a shear stress in the separation layer 111 due to a difference in contraction coefficient between the silicon substrate 100 and the plastic plate 170 when cooled, the solar cell can be readily separated from the silicon substrate 100 along the separation layer 111, and an improvement in throughput is realized. Additionally, the method makes it possible to manufacture high-quality solar cells without the problem that the solar cell unintentionally strips away while it is being made.

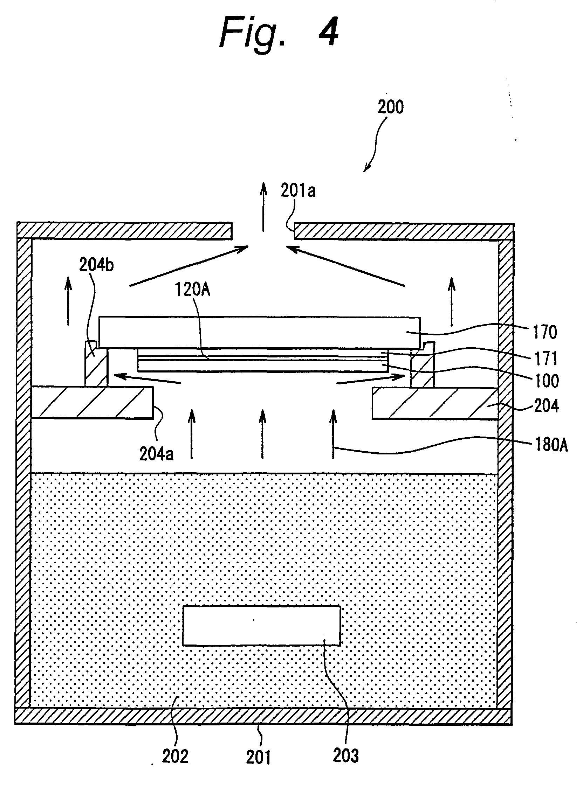

Next explained with reference to Fig. 4 is a cooling apparatus for realizing the cooling method employed in the foregoing embodiment.

The cooling apparatus 200 includes a container 201 which contains liquid nitrogen 202. A heater 203 is mounted in the container 201 to heat the liquid nitrogen 202. A support plate 204 having a central aperture 204a is fixed to the inner wall of the container 201 above the liquid nitrogen 202 to support a semi-product (the silicon substrate 100 before separation of the solar cell 120A) to be cooled with a support portion 204b formed along the aperture 204a. A top plate of the container 201 has an aperture 201a for discharging vapor after cooling.

After the solar cell 120A is formed in the epitaxial layer on the silicon substrate 100, and the plastic plate 170 is bonded to the solar cell 120A by the adhesive 171, in steps explained with reference to Figs. 1A through 2A, the silicon substrate 100 in this status is put on the support plate 204 in the cooling apparatus 200. After that, the liquid nitrogen 202 is heated by a heater 203 and evaporated into vapor 180A. Thus, the vapor 180A is blown onto the silicon substrate 100, adhesive 171 and plastic plate 170, and the silicon substrate 100, adhesive 171 and plastic plate 170 are gradually cooled. As a result, a shear stress is produced and increased in the separation layer 111 between the silicon substrate 100 and plastic plate 170, and finally starts separation of the plastic plate 170 and the solar cell 120A from the silicon substrate 100 along the separation layer 111 as shown in fig. 3A. Note here that the density of vapor 180A changes with temperature of the heater 203 and that the cooling speed can be controlled by adjusting the temperature of the heater 203. It is important to prevent sudden decrease of the temperature to prevent damages to the solar cell to be separated.

In the cooling apparatus of this type, in general, the temperature of the silicon substrate 100 and the plastic plate 170 can be decreased to approximately 100 K. If separation is not attained even at 100 K, the silicon substrate 100 and the plastic plate 170 may be immersed into the liquid nitrogen 202, or liquid helium vapor or dry ice may be blown, in order to further decrease the cooling temperature. When liquid helium is used, a helium recovery apparatus is preferably provided for cost reduction.

In a specific example where the porous silicon layer 110 was formed by anodic oxidation by electric conduction first for 8 minutes under the current density of approximately 1 mA/cm², next for 8 minutes under the current density of 8 mA/cm², and finally for 2.6 seconds under the current density of 200 mA/cm², and the plastic plate 170 was bonded to the solar cell by an ultraviolet setting adhesive as the adhesive 171, the solar cell could be separated from the silicon substrate 100 at the temperature of approximately 180 K.

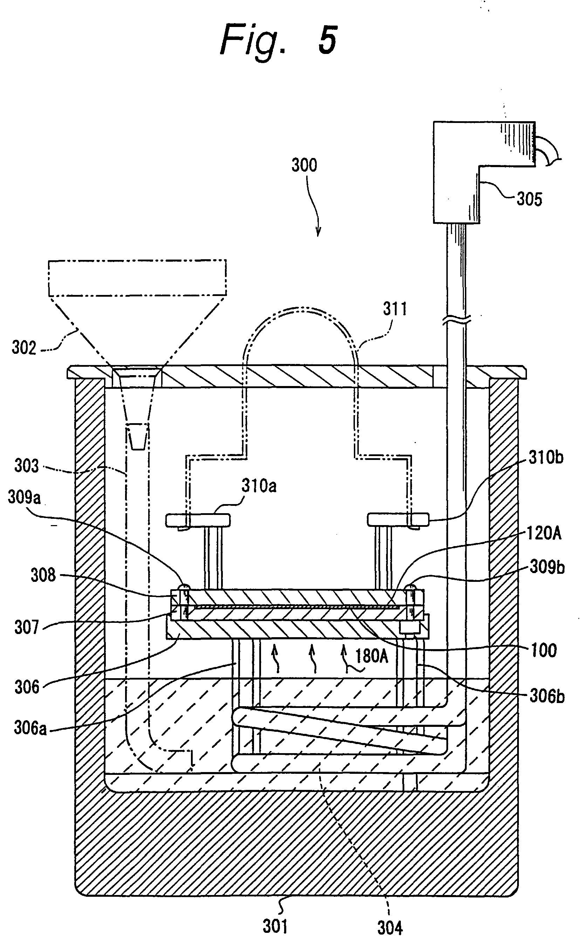

Fig. 5 shows the construction of an alternative cooling apparatus. In the cooling apparatus 300, liquid nitrogen 304 is supplied to the container 301 through a liquid nitrogen inlet 302 and a pipe 303, and the liquid nitrogen 304 is heated by a heater 305 and evaporated into vapor 180A. A fixation plate 306 supported by support legs 306a is mounted above the liquid nitrogen 304. The fixation plate 306 is made of a metal having a high heat conductivity, such as copper (Cu), for example. A hold plate 307 here again made of copper, for example, is fixed on the fixation plate 306. The solar cell 120A, formed on the silicon substrate 100 and having a transparent plastic plate 308 made of polycarbonate, for example, bonded thereto, is put on the hold plate 307. In this status, along the periphery of the transparent plastic plate 308, the transparent plastic plate 308 and the hold plate 307 are bound integrally by rivets 309a, 309b used as an anti-warpage means. The transparent plastic plate 308 has a pair of L-shaped engage portions 310a, 310b on its upper surface for engagement with a handle 311 when the transparent plastic plate 308 and the hold plate 307, after cooled, are removed together from the container 301.

After the solar cell 120A is formed in the epitaxial layer on the silicon substrate 100 in steps explained with reference to Figs. 1A through 2A, and the transparent plastic plate 308 is bonded to the solar cell 120A, the silicon substrate 100 in this status is put on the hold plate 307 in the cooling apparatus 300. After that, the liquid nitrogen 302 is heated by the heater 305 and evaporated into vapor 180A. Thus, the vapor 180A directly touches the fixation plate 306 and cools the fixation plate 306 and the hold plate 307 thereon to decrease their temperature. In this case, since the hold plate 307 is in contact over its entire area with the transparent plastic plate 308 and the silicon plate 100, the temperature of the transparent plastic plate 308 and the silicon plate 100 are cooled uniformly, and their temperature is decreased uniformly. As a result, similarly to the case using the cooling apparatus 200, the solar cell 120A is separated together with the transparent plastic plate 308 from the silicon substrate 100 due to a difference in contraction coefficient by cooling. The aspect of the separation can be visually observed from above the transparent plastic plate 308 through the transparent plastic plate 308. Although the transparent plastic plate 308 tends to warp away while it contracts due to cooling by liquid nitrogen vapor 180A, the transparent plastic plate 308 is bound,integrally with the hold plate 307 by rivets 309a, 309b as anti-warpage means, and such warpage is prevented. The anti-warpage means may be screws or other binding means instead of rivets 309a, 309b, or a weight of a metal may be put on the upper surface of the transparent plastic plate 308. It is also possible to combine two or more of these means.

In the first embodiment, if the separation layer 111 formed in the porous silicon layer 110 has a relatively large strength, an additional method of irradiating an ultrasonic wave or applying a tensile stress may be used in addition to cooling by the cooling means. In this case, the cooling temperature need not be so low as compared with the method relying on cooling means alone, and the energy of the ultrasonic wave and the tensile stress need not be large. Therefore, even a solar cell with a large area can be separated without damages.

### (Second Embodiment)

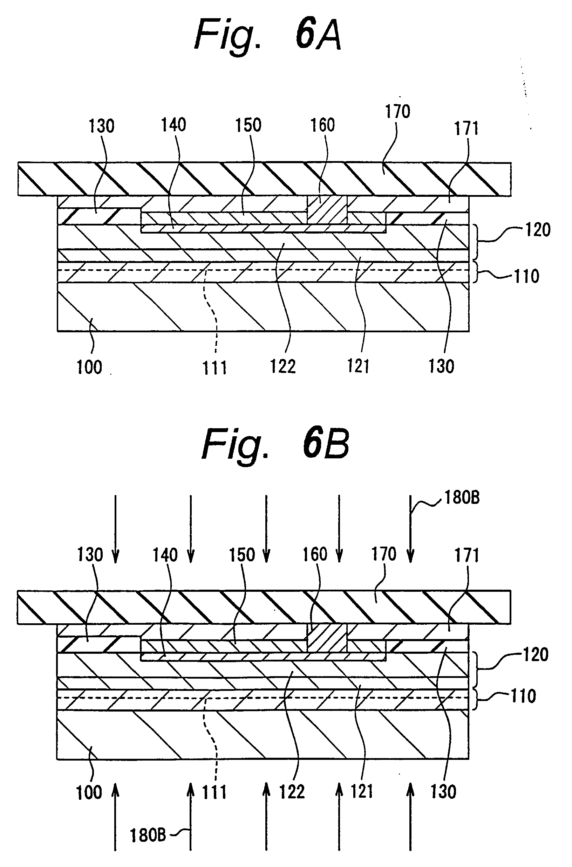

Next explained is a second embodiment of the invention. Parts or elements identical or equivalent to those of the first embodiment are labeled with common reference numerals, and their explanation is omitted. This embodiment is the same as the first embodiment from the step of forming the metal electrode 160 until bonding the plastic plate 170 as the second substrate onto the surface of the silicon substrate 100 by the adhesive (for example, ultraviolet setting adhesive ) 171 strong against a tensile force as shown in Fig. 6A. Therefore, subsequent steps alone are explained below.

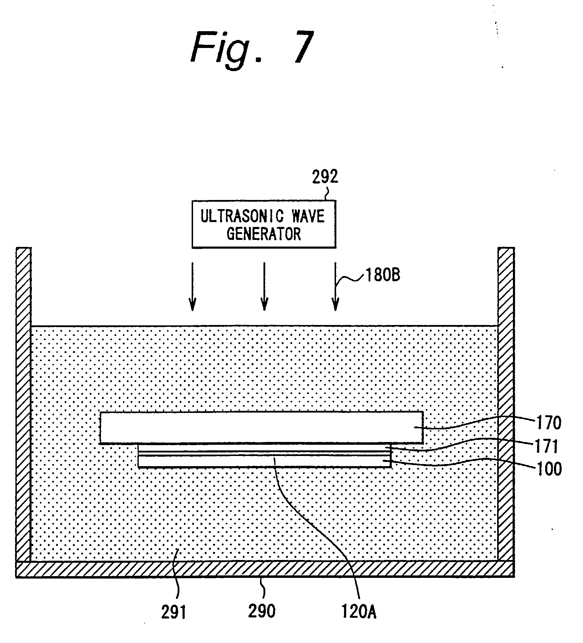

In this embodiment, as shown in Fig. 6B, an ultrasonic wave 180B is irradiated to the silicon substrate 100, solar cell 120A and plastic plate 170. More specifically, as shown in Fig. 7, the silicon substrate 100 having formed the solar cell 120A is immersed in a liquid 291, such as water or ethanol, contained in a container 290, and an ultrasonic wave 180B of 250 kHz and 600 W, for example, is irradiated from an ultrasonic wave generator 292. In this arrangement, the energy of the ultrasonic wave is effectively transmitted to the silicon substrate 100, solar cell 120A and plastic plate 170 to cut silicon atoms of the porous silicon layer 110 and to greatly weaken the tensile strength of the separation layer 111. As a result, similarly to the aspect shown in Fig. 3A of the first embodiment, the solar cell 120A and the plastic plate 170 on the epitaxial layer 120 are separated from the silicon substrate 100. That is, the solar cell 120A is transferred from the silicon substrate 100 to the plastic plate 170. Subsequent steps are the same as those of the first embodiment, and their explanation is omitted here.

According to the embodiment explained here, since an ultrasonic wave is used to weaken the tensile strength of the separation layer 111 in the porous silicon layer 110, the solar cell can be separated without decreasing the room temperature as required in the first embodiment. Additionally, this method makes it possible to manufacture solar cells with a large area and a high quality without the problem of unintentional separation during the solar cell being made. Moreover, since this embodiment need not apply a tensile stress, the solar cell does not receive a bending stress, and the problem of cleavage of the silicon substrate is eliminated.

In this embodiment, the tensile strength of the separation layer 111 becomes smaller as the energy of the ultrasonic wave becomes higher, or the frequency becomes lower, and the solar cell can be separated from the silicon substrate 100 and transferred to the plastic plate 170 only by irradiation of the ultrasonic wave. However, if the energy of the ultrasonic wave is too high, undesirable phenomenon such as cracking of the silicon substrate 100 may occur. Therefore, the energy of the ultrasonic wave should be determined to a value not cracking the silicon substrate 100. An ultrasonic wave in the range of 50 kHz to 100 kHz, for example, is unlikely to cause damages to the silicon substrate 100, and can be recommended for use in the embodiment.

In the above-explained embodiment, separation is done solely by irradiation of an ultrasonic wave. If irradiation of the ultrasonic wave is not sufficient for complete separation, then a tensile stress may be applied between the silicon substrate 100 and the plastic plate 170 in addition to irradiation of the ultrasonic wave. However, the tensile stress must be regulated within an appropriate range not to damages the epitaxial layer 120 having formed the solar cell.

If the use of the tensile stress in addition to irradiation of the ultrasonic wave is not sufficient for complete separation, the ultrasonic wave may be once again irradiated to further decrease the tensile strength of the separation layer 111 and to separate the solar cell from the silicon substrate 100. In this case, the energy of the ultrasonic wave irradiated to the silicon substrate is desirably increased by increasing the output of the ultrasonic wave than the former irradiation or by decreasing the frequency of the ultrasonic wave.

If the separation is not completed even by these means, a tensile force is once again applied between the silicon substrate 100 and the plastic plate 170. By repeating irradiation of the ultrasonic wave and application of a tensile stress, the tensile strength of the separation layer 111 gradually decreases to finally permit the separation.

If the separation is still difficult even after repeating irradiation of the ultrasonic wave and application of the tensile stress, then the separation layer 111 must be treated to exhibit a smaller tensile strength. That is, by elongating the time of anodic oxidation by several seconds or by increasing the current for anodic oxidation to absolutely decrease the tensile strength of the separation layer 111, for example, the solar cell can be readily separated form the silicon substrate 100. However, excessive decrease in tensile strength of the separation layer 111 will invite destruction of the solar cell while it is formed, and such situations must be avoided.

### (Third Embodiment)

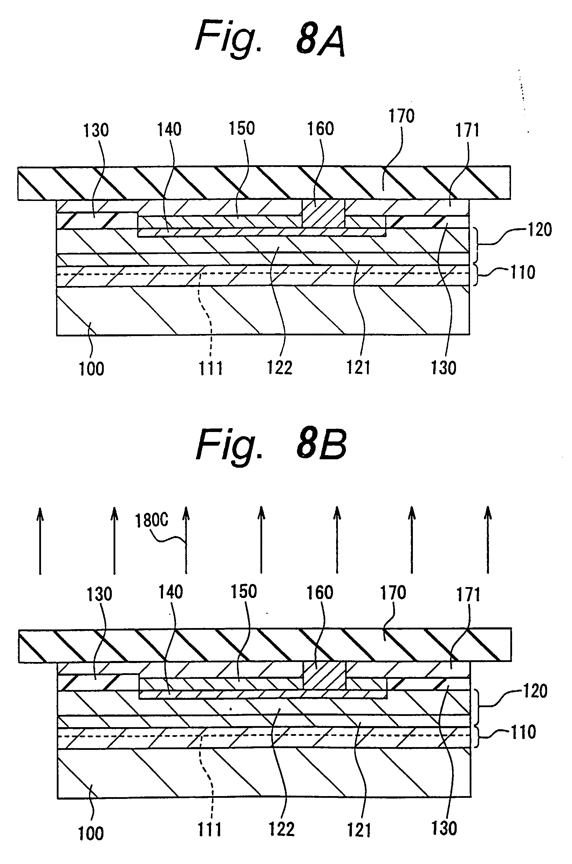

Next explained is a third embodiment of the invention. Parts or elements identical or equivalent to those of the first embodiment are labeled with common reference numerals, and their explanation is omitted. This embodiment is the same as the first and second embodiments from the step of forming the metal electrode 160 until bonding the plastic plate 170 as the second substrate onto the surface of the silicon substrate 100 by the adhesive (for example, ultraviolet setting adhesive ) 171 strong against a tensile force as shown in Fig. 8A. Therefore, subsequent steps alone are explained below.

In this embodiment, as shown in Fig. 8B, a centrifugal force 180B is applied to the solar cell and the plastic plate 170. The centrifugal force 180C cuts silicon atoms in the porous silicon layer 110 of the silicon substrate 100, and greatly weakens the tensile strength of the separation layer 111. As a result, similarly to the aspect shown in Fig. 3A of the first embodiment, the solar cell and the plastic plate 170 on the epitaxial layer 120 are separated from the silicon substrate 100. That is, the solar cell is transferred from the silicon substrate 100 to the plastic plate 170. Subsequent steps are the same as those of the first embodiment, and their explanation is omitted here.

According to the embodiment explained here, since a centrifugal force is applied to decrease the tensile strength of the separation layer 111 in the porous silicon layer 110 after the plastic plate as the second substrate is bonded to the solar cell, the solar cell can be readily separated together with the plastic plate 17. This method enables fabrication of the solar cell without the problem of unintentional separation of the solar cell during formation thereof. Moreover, the method explained here can be conducted at the room temperature like the second embodiment, and requires less time for separation of the solar cell than the first and second embodiments. Therefore, a further improvement in through-put is realized.

Additionally, the embodiment explained here enables separation of elements of the same material, such as silicon from silicon, which is required for fabrication of a three-dimensional LSI (Large Scale Integrated circuit). That is, when two bonded silicon layers are to be separated, since they are identical in material and linear expansion coefficient, no stress occurs in the polycrystalline silicon layer even by changing the temperature (cooling) like the first embodiment. Theoretically, therefore, the method according to the first embodiment is not applicable to fabrication of three-dimensional LSI. In contrast, the embodiment shown here uses a centrifugal force instead of temperature variation. Since the centrifugal force applied to the unit area concentrates to the column portion of the separation layer 111, the layers of the same material, such as silicon-silicon, can be separated along the separation layer 111.

If the centrifugal force alone is not sufficient for complete separation, a tensile stress may be additionally applied between the silicon substrate 100 and the plastic plate 170 to promote separation. Moreover, the cooling method used in the first embodiment and irradiation of an ultrasonic wave used in the second embodiment may be combined.

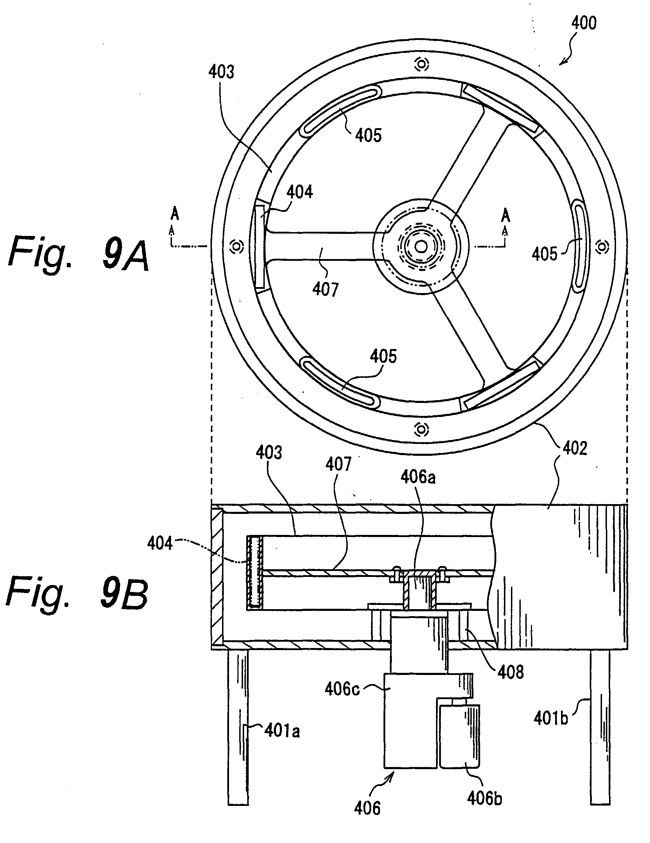

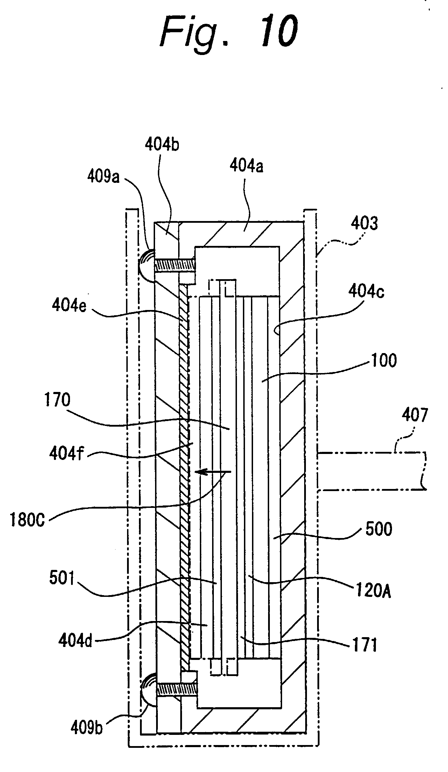

A centrifugal separator for realizing centrifugal separation according to the embodiment is explained below in detail with reference to Figs. 9 and 10.

The centrifugal separator 400 includes a ring-shaped rotary body 403 within a casing 402 supported by two support legs 401a, 401b, for example. The rotary body 403 is made of a light material, such as duralmin, and configured to set a plurality of, i.e. three, transfer holders 404 inside it through an aperture formed in its upper plate. These transfer holders 404 are preferably located in equal intervals. Balancers 405 are also set in the rotary body 403 between the transfer holders 404 to smooth rotation of the rotary body 403.

The centrifugal separator 400 further includes a driver 406 as means for applying a centrifugal force for rotating the rotary body 403. The driver 406 is located at a central position of the rotary body 403, and includes a rotary shaft 406a coupled to the rotary body 403 through three arms 407, for example, a drive motor 406b located under the casing 403, and gear mechanism 406c transmitting the driving power of the drive motor 406b to the rotary shaft 406a. The entirety of the driver 406 is fixed to the bottom of the protective casing 403 via a support 408.

Fig. 10 shows a specific construction of each transfer holder 404 set in the rotary body 403 of the centrifugal separator 400. The transfer holder 404 is a box-shaped element large enough to contain a semi-product, and may be made of a light metal, such as duralmin. The transfer holder includes a main body 404a open to its front end, for example, and a cover 404b covering the opening of the main body 404a. The cover 404b is attached to the main body 404a by screws 409a, 409b, for example. An inner vertical wall surface of the main body 404a behaves as a hold portion 404c to which the back surface of a semi-product silicon substrate 100 inserted through the opening is bonded by an adhesive 500. A metal plate 404d of copper (Cu), for example, used as a weight is bonded to the plastic plate 170 as the second substrate by an adhesive 501. On the other hand, a damping element 404e made of sponge, for example, is bonded to an inner wall surface of the cover 404b. A gap 404f is provided between the damping element 404e and the metal plate 404d bonded to the plastic plate 170.

In the centrifugal separator 400, when the drive motor 406b rotates, its driving power is transmitted to the rotary shaft 406a through the gear mechanism 406c. As a result, the rotary body 403 rotates, and a centrifugal force 180C is applied to the metal plate 404 and the plastic plate 170 in the transfer holder 404 as shown by the arrow in Fig. 10. Due to the centrifugal force 180C, the solar cell 120A and the plastic plate 170, together with the metal plate 404d, are separated from the silicon substrate 100 as shown by the dots-and-dash line. The solar cell 120A and the plastic plate 170 separated from the silicon substrate 100 fly toward the cover 404b. However, since the damping element 404d is bonded to the cover 404b, the metal plate 404d hits the damping element 404e and stops there. Therefore, the solar cell 120A is never damaged. The metal plate 404d is removed from the plastic plate 170 after separation of the solar cell 120A.

Since the centrifugal force F generated by the centrifugal separator 400 is determined, in general, by mrω² (m: mass, r: rotational radius, and ω: angular velocity), the embodiment may rely on increasing the length (r) of the arm 407, revolution (ω) or mass (m) to increase the centrifugal force. Considering that an increase of the length (r) of the arm 407 results in increasing the size of the apparatus, the length of the arm 407 used in the embodiment is 30 cm, for example. Additionally, considering that an increase of the revolution (ω) results in applying a large load to the drive motor, a motor of 1000 to 5000 rpm, for example, is used. That is, the embodiment mainly rely on an increase of the mass (m) by bonding the metal plate 404 to the plastic plate 170 to increase the centrifugal force. For example, when the length (r) of the arm 407 is 30 cm, and a motor whose revolution (ω) is 300 rpm is used, a metal plate with the thickness of 2 mm per 1 cm² may be used to apply a centrifugal force as large as five times the gravity when the metal plate is made of copper (Cu) .

If a spindle motor rotatable at a high speed around decade thousands rpm, for example, is used as the drive motor, then a sufficient centrifugal force can be obtained without using the metal plate. For example, if the revolution of the motor is 30,000 rpm, the centrifugal force is equivalent to 500 times the gravity. Therefore, it is sufficient to bond a PC plate with the thickness of approximately 0.2 mm in order to obtain a centrifugal force equivalent to five times the gravity. Although the centrifugal force is referred to as being five times the gravity for convenience in calculation, the same is applicable also to a sufficiently small sample in which the strength of the porous silicon layer is 1 G or less.

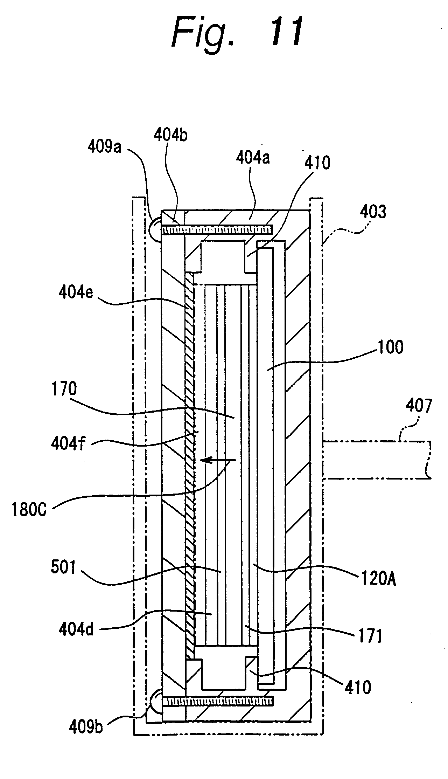

The foregoing embodiment has been explained as bonding the silicon substrate 100 to a wall surface (hold portion 404c) in the transfer holder 404 by an adhesive. However, the arrangement shown in Fig. 11, for example, may be used alternatively. In Fig. 11, the plastic plate 170 has a smaller diameter than that of the silicon substrate 100, and a wall surface of the transfer holder 404 confronting to the periphery of the silicon substrate 100 form a hold portion 410. In this arrangement, when a centrifugal force is applied similarly to the above case, the silicon substrate 100 is engaged by the hold portion 410 along its peripheral edge, and the solar cell 120A and the plastic plate 170 are separated in the same manner. Since this arrangement requires no adhesive, the silicon substrate after separation of the solar cell 120A can be readily removed from the transfer holder 404 to ensure more reliable re-use of the silicon substrate.

Moreover, although the foregoing embodiment has been explained as the hold portion 404c grasping the silicon substrate 100 as the first substrate in the transfer holder 404, the holder 404c may be configured to grasp the plastic plate 170 as the second substrate. However, the structure of the embodiment configured to grasp the silicon substrate 100 at the hold portion 404c is preferable because the plastic plate 170 is more suitable for attaching the metal plate, and the plastic plate 170 having attached the metal plate is heavier and more likely to separate than the silicon substrate.

Location the opening of the transfer holder 404 may be selected as desired, for example, on the top end, although it is on the front end in the foregoing embodiment.

Although the invention has been described by way of various embodiments, the invention is not limited to these specific examples, but rather involves various changes and modifications within the range of equivalents. For example, although the first to third embodiments have been explained as making a solar cell as the thin-film semiconductor device, any appropriate thin-film device, such as photo detector, light emitting device, liquid crystal display device, integrated circuit device, or the like, may be made. Also these devices may be made of a polycrystalline or amorphous layer, or their compound film, instead of a single-crystal layer.

Although the embodiments have been explained as using the plastic plate 170 as the second substrate, also usable are a glass plate, SUS (stainless steel) or other metal plate, and a silicon or other semiconductor substrate, case by case.

Next explained are a solar cell module and its manufacturing method according to the invention.

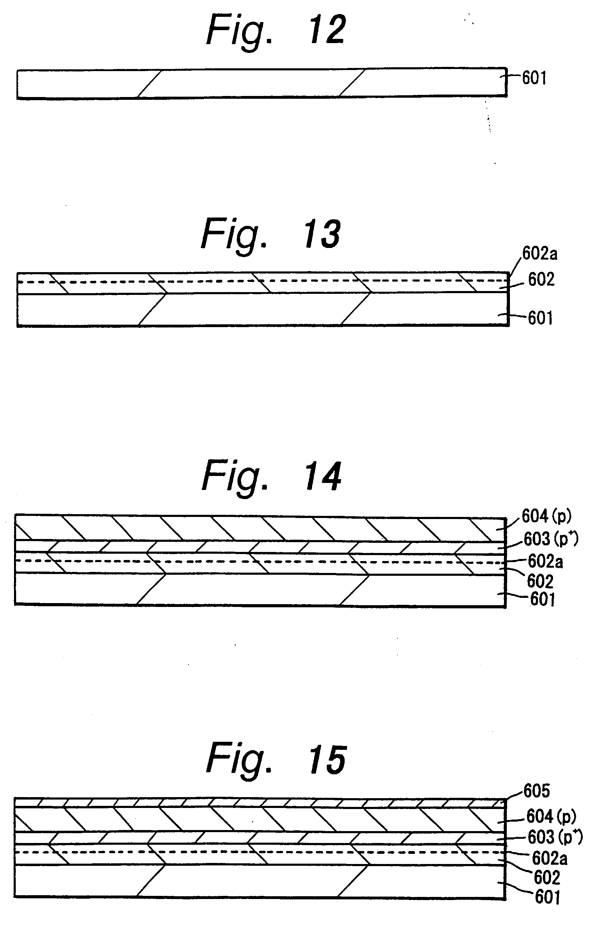

Figs. 12 through 25 show a process for manufacturing a thin-film single-crystal silicon solar cell, taken as the fourth embodiment of the invention. The thin-film single-crystal silicon solar cell is made in form of a monolithic device containing an appropriate number of such thin-film single-crystal silicon solar cells required for a specific use. In Figs. 12, through 25, only two thin-film single-crystal silicon solar cells are shown.

In the fourth embodiment, first prepared is a single-crystal silicon substrate 601 as shown in Fig. 12. The single-crystal silicon substrate 601 is preferably of a p-type from the viewpoint that the a porous silicon layer is to be made thereon by anodic oxidation explained later. However, even if an n-type substrate is used, the porous silicon layer can be made under appropriately determined conditions. The Single-crystal silicon substrate 601 has a specific resistance in the range of 0.01 to 0.02, for example.

Next formed on the surface of the single-crystal silicon substrate 601 is a porous silicon layer 602 by anodic oxidation as shown in Fig. 13. The porous silicon layer 602 is made in three different steps. In the first step, in order that an epitaxial layer having a good crytallographic property be made on the porous silicon layer 602, anodic oxidation is done for 8 minuets, for example, under the current density of approximately 0.5 to 3 mA/cm², for example, to form a porous silicon layer with a small porosity. In the next second step, anodic oxidation is executed for 8 minutes, for example, under the current density of approximately 3 to 20 mA/cm², for example, to make a porous silicon layer with an intermediate porosity. In the next third step, anodic oxidation is done for several seconds, for example, under the current density of approximately 40 to 300 mA/cm², for example, to make a porous silicon layer with a large porosity. By anodic oxidation in the third step, a thin porous silicon layer 602a having a very large porosity as the origin of the separation layer is formed in the porous silicon layer 602. For anodic oxidation in respective steps, an anodic oxidation solution containing HF:C₂H₅OH = 1:1, for example. Considering that the single-crystal silicon substrate 601 is used repeatedly, the thickness of the porous silicon layer 602 is preferably as thin as possible, preferably in the range of 5 to 15 µm, more preferably around 8 µm, for example, to alleviate the decrease in thickness of the single-crystal silicon substrate 601 and to maximize the re-usable time.

Next conducted is hydrogen annealing for 30 minutes at the temperature of 1100°C, for example, to cover holes opening to the surface of the porous silicon layer 602. Thereafter, as shown in Fig. 14, a p⁺-type single-crystal silicon layer 603 and a p-type single-crystal silicon layer 604 are epitaxially grown in sequence on the porous silicon layer 602 at 1070°C, for example, by CVD using SiH₄, for example, as the material gas. The total thickness of the p⁺-type single-crystal silicon layer 603 and the p-type single-crystal silicon layer 604 is preferably 1 to 50 µm. The p⁺-type single-crystal silicon layer 603 has an impurity concentration around 10¹⁹/cm³, for example, and a thickness around 1 µm. The p-type single-crystal silicon layer 604 has an impurity concentration around 10¹⁵ to 10¹⁸/cm³, for example, and a thickness in the range of 1 to 49 µm, for example.

During the hydrogen annealing and the epitaxial growth, silicon atoms in the porous silicon layer 602 move and recombine. As a result, the thin porous silicon layer 602a having a large porosity in the porous silicon layer 602 becomes a layer with a very low tensile strength, namely, the separation layer.

After that, a silicon oxide layer 605 is formed on the entire surface of the p-type single-crystal silicon layer 604 by thermal oxidation or CVD, as shown in Fig. 15.

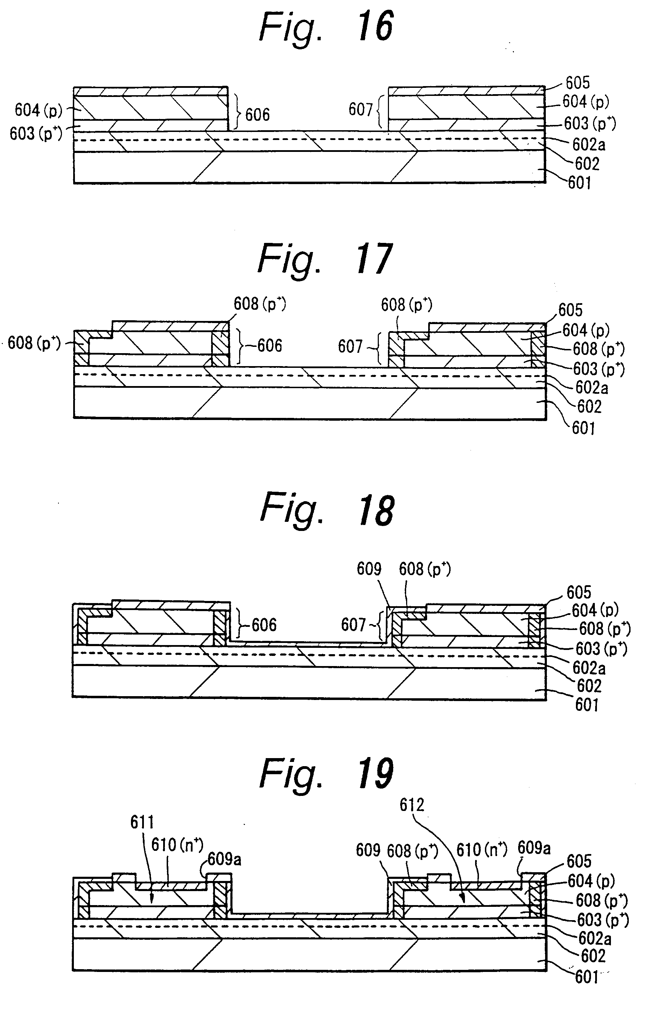

Next, as shown in Fig. 16, a resist pattern (not shown) of a configuration corresponding to the solar cell to be made is formed on the silicon oxide film 605 by lithography, and the silicon oxide film 605 is etched using the resist pattern as a mask. The resist pattern is removed thereafter. Then, the patterned silicon oxide film 605 is used as a mask to sequentially wet-etch the p-type single-crystal silicon layer 604 and the p⁺-type single-crystal silicon layer 603 sequentially, using an alkali etchant, such as KOH. As a result, separate solar cell layers 606, 706 each made of the p⁺-type single-crystal silicon layer 603 and the p-type single-crystal layer 604 are obtained. To fully separate the solar cell layers 606, 607, the wet etching may be continued until an upper part of the porous silicon layer 602 is etched. However, as explained later, the wet etching is preferably stopped before reaching the porous silicon layer 602a as the separation layer, in order to facilitate separation of the solar cell layers 606, 607 from the single-crystal silicon substrate 601.

Next, as shown in Fig. 17, the silicon oxide film 605 is partly removed by etching until exposing the p-type single-crystal silicon layer 604 overlying end portions of the solar cell layers 606, 607. After that, by diffusing a p-type impurity, such as boron, into the exposed portions and side wall portions of the solar cell layers 606, 607 to form p⁺-type single-crystal silicon layers 608.

Next, as shown in Fig. 18, a silicon oxide film 609 is formed by thermal oxidation or CVD to cover exposed surfaces of the p⁺-type single-crystal silicon layers 608.

Next, as shown in Fig. 19, the silicon oxide film 906 is selectively removed by etching to make apertures 609a, and an n-type impurity, such as phosphorus, is diffused into the p-type single-crystal silicon layer 604 through the apertures 609a to form n⁺-type single-crystal silicon layers 610.

Each n⁺-type single-crystal silicon layer 610, p-type single-crystal silicon layer 604 and p⁺-type single-crystal silicon layer 603 construct a thin-film single-crystal silicon solar cell 611 or 612 having an n⁺-p-p⁺ structure. The n⁺-type single-crystal silicon layer 610 and the p⁺-type single-crystal silicon layer 608 behave as the cathode and the anode of each thin-film single-crystal silicon solar cell 611 or 612. The p⁺-type single-crystal silicon layers 603 have the role of increasing the conversion efficiency of the thin-film single-crystal silicon solar cells 611, 612. That is, since electrons generated by incident light into the p-type single-crystal silicon layer 604 are reflected by the p⁺-type single-crystal silicon layer 603, recombination of electron-hole pair decreases in the p⁺-type single-crystal silicon layer 603, and a high conversion efficiency is realized.

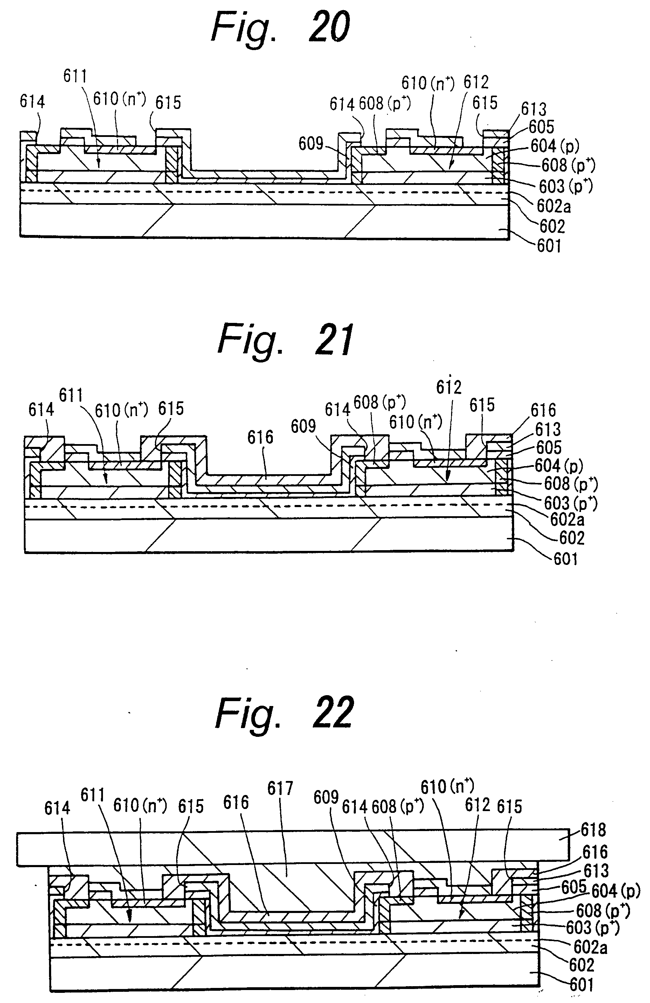

Next, as shown in Fig. 20, an anti-reflection film 613 in form of a silicon nitride film, for example, is formed on the entire surface by CVD, for example, and the anti-reflection film 613 and silicon oxide film 609 are selectively removed by etching to form apertures 614 and 615 where the p⁺-type single-crystal silicon layer 608 and the n⁺-type single-crystal silicon layer 610 are exposed.

After that, a metal film such as aluminum film, for example, is formed on the entire surface by vacuum evaporation or sputtering, for example, and then patterned into a predetermined configuration by etching. As a result, a metal electrode 616 is formed as shown in Fig. 21. In this status, the n⁺-type single-crystal silicon layer 610 behaving as the cathode of the thin-film single-crystal silicon solar cell 611 and the p⁺-type single-crystal silicon layer 608 behaving as the anode of the thin-film single-crystal silicon solar cell 612 are connected by the metal electrode 616.

Next, as shown in Fig. 22, a transparent substrate 618 made of a transparent plastic film, for example, is bonded to surfaces of the thin-film single-crystal silicon solar cells 611, 612 by using an adhesive 617 preferably having a high tensile strength.

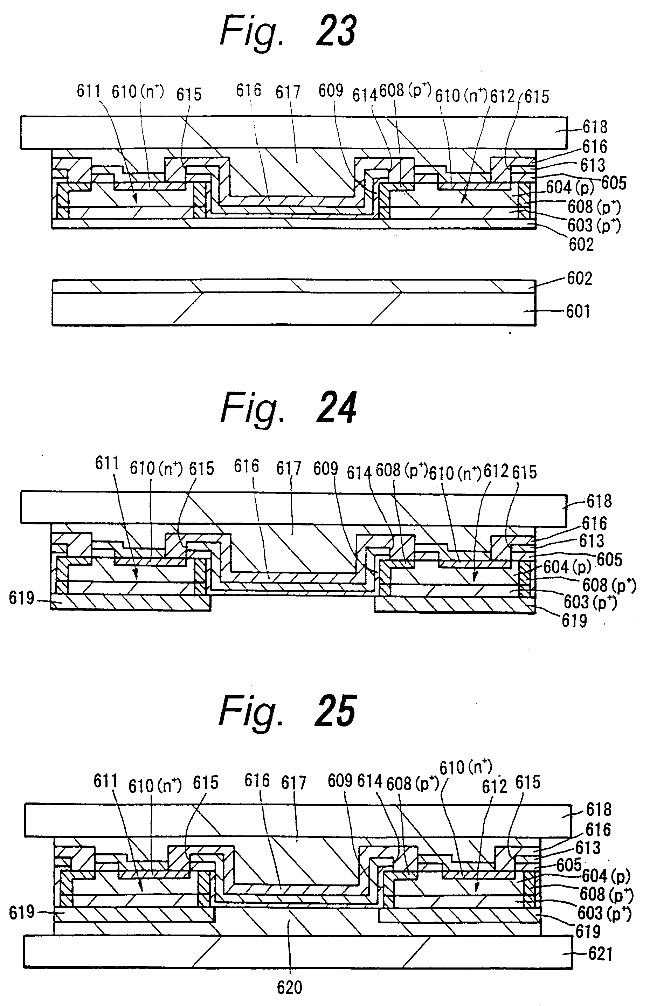

After that, while the single-crystal silicon substrate 601 is immersed in water or ethanol solution, for example, an ultrasonic wave with the frequency of 25 kHz and the power of 600 W, for example, is irradiated to decrease the separation strength of the porous silicon layer 602a as the separation layer due to the energy of the ultrasonic wave and to separate the single-crystal silicon substrate 601 along the porous silicon layer 602a as shown in Fig. 23. Alternatively, tensile forces in opposite directions may be applied to the transparent substrate 618 and the single-crystal silicon substrate 601 to separate the single-crystal silicon substrate 601 along the porous silicon layer 602a as the separation layer. Alternatively, the single-crystal silicon substrate 601 and the transparent substrate 618 may be cooled by blowing cold nitrogen gas evaporated from liquid nitrogen, for example, to produce a shear stress caused by a difference in thermal contraction between the single-crystal silicon substrate 601 and the transparent substrate 618 and to thereby separate the single-crystal silicon substrate 601 along the porous silicon layer 602a as the separation layer. Alternatively, two or more of the above-mentioned processes may be combined to separate the single-crystal silicon substrate 601 along the porous silicon layer 602a as the separation layer.

In this status, the thin-film single-crystal silicon solar cells 611, 612 are short-circuited by the porous silicon layer 602 remaining on their back surfaces. Therefore, wet-etching is done using an alkali etchant, for example, to remove the porous silicon layer 602 from the back surface of the thin-film single-crystal silicon solar cells 611 and to fully isolate these thin-film single-crystal silicon solar cells 611, 612 from each other as shown in Fig. 24.

After that, a metal film, such as aluminum film, is formed on the entire bottom surface of the thin-film single-crystal silicon solar cells 611, 612 by vacuum evaporation or sputtering, for example, and the metal film is patterned into a predetermined configuration by etching to form metal electrodes 619 on bottom surfaces of the thin-film single-crystal silicon solar cells 611, 612. By lining the bottom surfaces of the thin-film single-crystal silicon solar cells 611, 612 by the metal electrodes 19, the serial resistances of the thin-film single-crystal silicon solar cells 611, 612 can be decreased. This is especially effective when the thin-film single-crystal silicon solar cells 611, 612 are wide and their serial resistances are large. These metal electrodes 619 also function as reflective mirrors for reflecting light passing through the thin-film single-crystal silicon solar cells 611, 612, and hence increase the conversion efficiency of the thin-film single-crystal silicon solar cells 611, 612.

After that, as shown in Fig. 25, a substrate 621 made of a plastic film, for example is bonded to the bottom surfaces of the thin-film single-crystal silicon solar cells 611, 612 by an adhesive 620.

As a result, monolithic thin-film single-crystal silicon solar cells separated from each other and connected in series are completed on the transparent substrate 618.

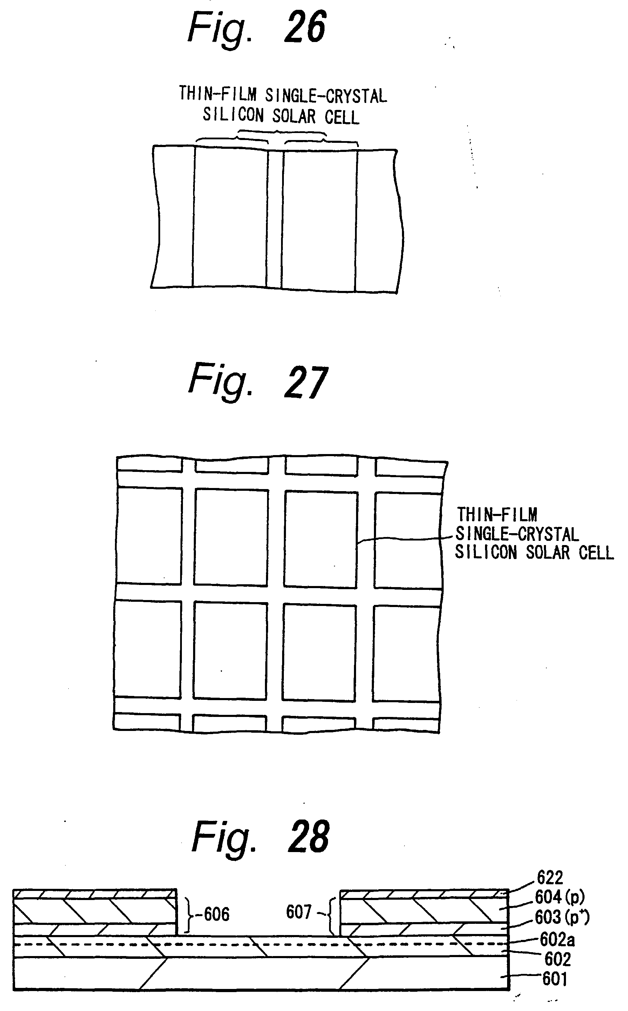

A plan-view configuration of the thin-film single-crystal silicon solar cells is shown in Fig. 26, and another in Fig. 27. In the example of Fig. 26, a plurality of strip-shaped thin-film single-crystal silicon solar cells are formed and isolated by separation regions. In the example of Fig. 27, a plurality of rectangular thin-film single-crystal silicon solar cells are formed and isolated by longitudinal and transverse separation regions.

According to the forth embodiment, the following advantages are obtained. That is, since a plurality of thin-film single-crystal silicon solar cells are made in form of a monolithic device in an isolated relationship on the transparent substrate 618, the cost of solar cell modules can be reduced remarkably, and hence the cost of solar cells can be decreased. Moreover, the monolithic design contributes to miniaturization of solar cells, and permits a variety of designs of portable appliances in which solar cells are mounted. Further, since the thin-film single-crystal silicon solar cells comprises a thin-film solar cell layer and flexible transparent substrate 618 and substrate 612, flexible solar cells having a high conversion efficiency can be realized, and applications of solar cells are increased remarkably. In particular, with regard of the flexibility, since a plurality of thin-film single-crystal solar cells are held in an isolated relationship on the transparent substrate 618 and the substrate 621, and the adhesive 617 fills portions between adjacent thin-film single-crystal silicon solar cells, the product has a sufficient strength against a certain degree of bending. Additionally, by using a rectangular single-crystal silicon substrate obtained by cutting a single-crystal silicon ingot obtained by crystal growth along its lengthwise direction, for example, solar cells extending over a large area as large as square meters can be realized.

Moreover, after the porous silicon layer 602 formed on the single-crystal silicon substrate 601 is removed, the silicon substrate 601 restores the original status shown in Fig. 12, and can be reused to execute the step shown in Fig. 13. That is, the single-crystal silicon substrate 610 can be re-used, the cost of thin-film single-crystal silicon solar cells can be decreased. More specifically, if the thickness of the porous silicon layer 602 is 8 µm, and a thickness around 3 µm of the single-crystal silicon substrate 601 is lost by polishing for its re-use, then the single-crystal silicon substrate 601 loses the thickness 11 µm in one cycle of the manufacturing process of thin-film single-crystal silicon solar cells. Therefore, even after the single-crystal silicon substrate 601 is used ten times, the single-crystal silicon substrate 601 loses the thickness of only 110 µm. Thus, the single-crystal silicon substrate 601 can be used at least ten times.

Etching or electrolytic polishing may be used for removal of the porous silicon layer 602 formed along the surface of the single-crystal silicon substrate 601. An example of conditions for removing the porous silicon layer 602 by electrolytic polishing is: the electrolytic polishing solution being a solution with a low HF concentration, namely, HF:C₂H₅OH = 1:1, for example, and the current density being 400 mA/cm².

Moreover, according to the fourth embodiment, since the solar cell layers are separated into a plurality of regions by etching, the thin-film single-crystal silicon solar cells can be readily separated from the single-crystal silicon substrate 601, and no trouble occurs there. That is, in order to facilitate separation of the thin-film single-crystal silicon solar cells from the single-crystal silicon substrate 601, the tensile strength of the porous silicon layer 602a in the porous silicon layer 602, i.e. the separation layer, may be made small. However, when it is excessively weak, a stress by heat increases and may results in unintentional separation of the solar cell layers from the single-crystal silicon substrate 601 while the product is put under a high-temperature condition in the manufacturing process of solar cells, namely, during diffusion of an impurity, for example. However, in the fourth embodiment, separation of solar cell layers 606, 607 is attained by wet etching using an alkali etchant, the stress applied to the solar cell layers 606, 607 are alleviated remarkably, and unintentional separation of the solar cell layers 606, 607 can be prevented effectively even when the product is exposed to a high temperature in subsequent steps. Especially when producing solar cells extending over a large area as large as 10 cm² or more, unintentional separation of solar cell layers in the manufacturing process of solar cells was a serious issue. Taking it into consideration, the method according to the fourth embodiment which can cut and separate the solar cell layer into parts of the size around 10 cm² prior to a high-temperature process is remarkably excellent, and can realize solar cells extending over an area as large as square meters as indicated above.

Next explained is a thin-film single-crystal silicon solar cell according to the fifth embodiment of the invention.

In the fifth embodiment, as shown in Fig. 28, the same steps as those of the fourth embodiment are executed until the p-type single-crystal silicon layer 604 is formed. After that, a single-layer film of silicon nitride, or a compound film combining a silicon nitride film and a chrome or metal film, is formed on the p-type single-crystal silicon layer 604 by CVD, vacuum evaporation or sputtering. Then, the film is patterned into a shape of solar cells by etching to form a mask 622. By using the mask 622, selective portions of the p-type single-crystal silicon layer 604 and the p⁺-type not covered by the mask 622 are changed to a porous layer by anodic oxidation. Then, the porous silicon layer, thus obtained, is removed by wet etching using Noah liquid to form isolated solar cell layers 606, 607. The porous silicon layer can be removed easily by wet etching using Noah liquid.

After that, the process is progressed in the same manner as the fourth embodiment, and intended thin-film single-crystal silicon solar cells are completed.

Also the fifth embodiment gives the same advantages as those of the fourth embodiment.

Next explained is a thin-film single-crystal silicon solar cell according to the sixth embodimnt of the invention.

In the sixth embodiment, the same steps as those of the fourth embodiment are executed until forming the p-type single-crystal silicon layer 604 as shown in Fig. 28. After that, here again, a single-layer film of silicon nitride, or a compound film combining a silicon nitride film and a chrome or metal film, is formed on the p-type single-crystal silicon layer 604 by CVD, vacuum evaporation or sputtering. Then, the film is patterned into a shape of solar cells by etching to form the mask 622. By using the mask 622, selective portions of the p-type single-crystal silicon layer 604 and the p⁺-type single-crystal silicon layer 603 not covered by the mask 622 are changed to a porous layer by anodic oxidation. Additionally, the porous silicon layer is oxidized to form a silicon oxide layer (not shown) to form isolated solar cell layers 606, 607. In this case, the silicon nitride film forming the mask 622 is used as the mask for oxidization.

After that, the process is progressed in the same manner as the fourth embodiment, and intended thin-film single-crystal silicon solar cells are completed.

Also the sixth embodiment gives the same advantages as those of the fourth embodiment.

Next explained is a method for manufacturing thin-film single-crystal silicon solar cells according to the seventh embodiment of the invention.

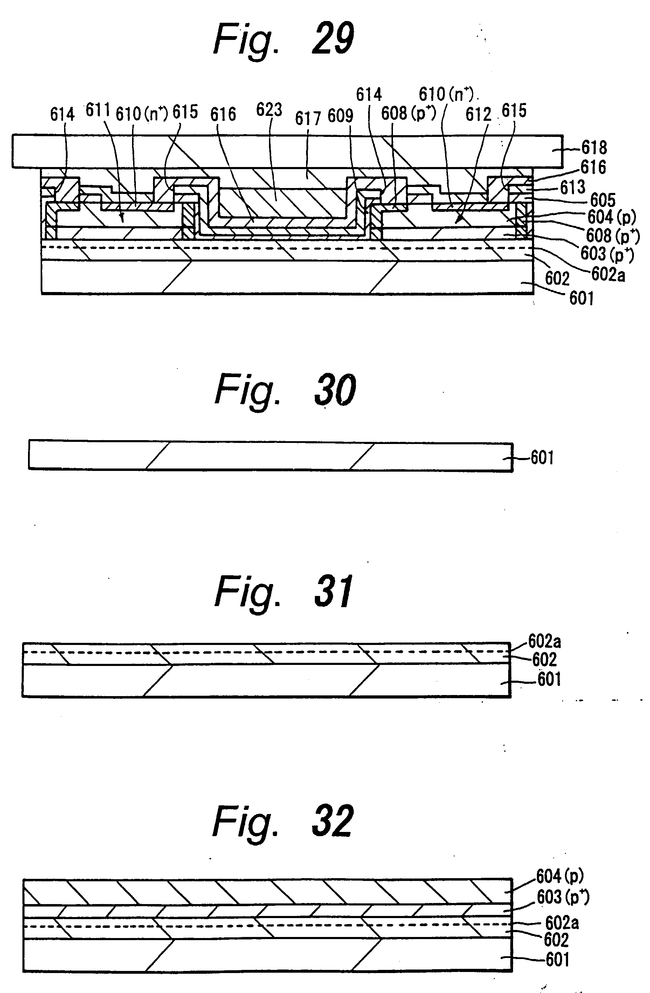

In the seventh embodiment, the same steps as those of the fourth embodiment are executed until the metal electrode 616 is formed as shown in Fig. 29. After that, spaces between thin-film single-crystal silicon solar cells 611, 612 are filled with a soft material 23, such as adhesive or fibers, for example, having a strength against bending. Usable as the soft adhesive is an adhesive which does not set with ultraviolet rays, such as thermoplastic rubber adhesive or polyurethane adhesive. An appropriate fiber material is nylon or other transparent fibers.

Subsequently, the same steps as those of the fourth embodiment are executed, and intended thin-film single-crystal silicon solar cells are completed.

Also the seventh embodiment attains the same advantages as those of the fourth embodiment, and attains an additional advantage, namely, realization of thin-film single-crystal silicon solar cells flexibly resisting against bending.

Next explained is a method for manufacturing thin-film single-crystal silicon solar cells according to the eighth embodiment of the invention. Fig. 30 through 40 illustrate steps of the method according to the eighth embodiment.

In the eighth embodiment, as shown in Figs. 30 and 32, the same steps as those of the fourth embodiment are executed to sequentially form on the single-crystal silicon substrate 601 the porous silicon layer 602, p⁺-type single-crystal silicon layer 603 and p-type single-crystal silicon layer 604.

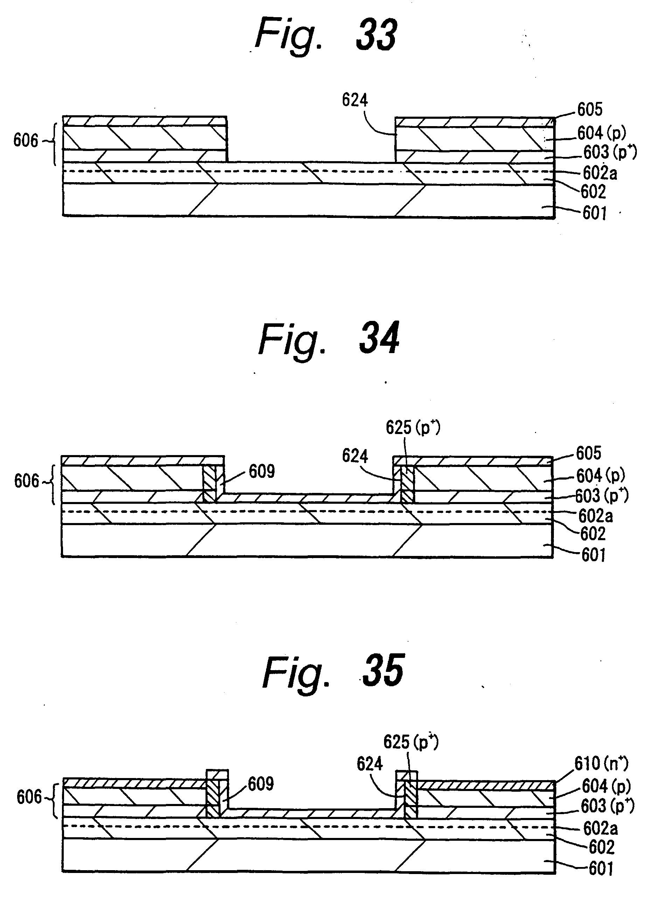

After that, as shown in Fig. 33, a silicon oxide film 605 is formed on the entire surface of the p-type single-crystal silicon layer 604, and then patterned by etching into a configuration corresponding to fine holes to be made. Using the patterned silicon oxide film 605 as a mask, the p-type single-crystal silicon layer 604 and the p⁺-type single-crystal silicon layer 603 are wet-etched sequentially, using an alkali etchant, such as KOH, to make a plurality of fine holes 624. Since the fine holes 624 permit light to pass through, the thin-film single-crystal silicon solar cells become see-through. The diameter of each fine hole 624 is determined appropriately, depending on the intended use of the thin-film single-crystal silicon solar cells, for example, in the range of 1 µm to the order of cm. Although the wet-etching is continued until an upper part of the porous silicon layer 602 is removed, it is preferably stopped before reaching the porous silicon layer 602a as the separation layer in order to facilitate later separation of the solar cell layer 606 from the single-crystal silicon substrate 601.

Next, as shown in Fig. 34, a p-type impurity, such as boron, is diffused into inner walls of the fine holes 624 not covered by the silicon oxide film 605 to form p⁺-type single-crystal silicon layers 625. Then, silicon oxide films 609 are formed by thermal oxidation or CVD to cover exposed surfaces of the p⁺-type single-crystal silicon films 609. The p⁺-type single-crystal silicon layers 625 have the same role as the p⁺-type single-crystal silicon layer 603. That is, electrons generated by incident light into the p-type single-crystal silicon layer 604 are reflected by the p⁺-type single-crystal silicon layers 625, recombination of electron-hole pairs decreases in the p⁺-type single-crystal silicon layers 625, and the conversion efficiency of the thin-film single-crystal silicon solar cell 611 can be increased.

Next, as shown in Fig. 35, the silicon oxide film 605 is selective removed by etching to partly expose the p-type single-crystal silicon layer 604. Then, an n-type impurity, such as phosphorus, is diffused into the exposed p-type single-crystal silicon layer 604 to form n⁺-type single-crystal silicon layers 610.

Similarly to the fourth embodiment, each n⁺-type single-crystal silicon layer 610, p-type single-crystal silicon layer 604 and p⁺-type single-crystal silicon layer 603 construct a thin-film single-crystal silicon solar cell 611 having an n⁺-p-p⁺ structure. In this case, the n⁺-type single-crystal silicon layer 610 behaves as the cathode of the thin-film single-crystal silicon solar cell 611, and the p⁺-type single-crystal silicon layer 603 behave as the cathode of the thin-film single-crystal silicon solar cell 611.

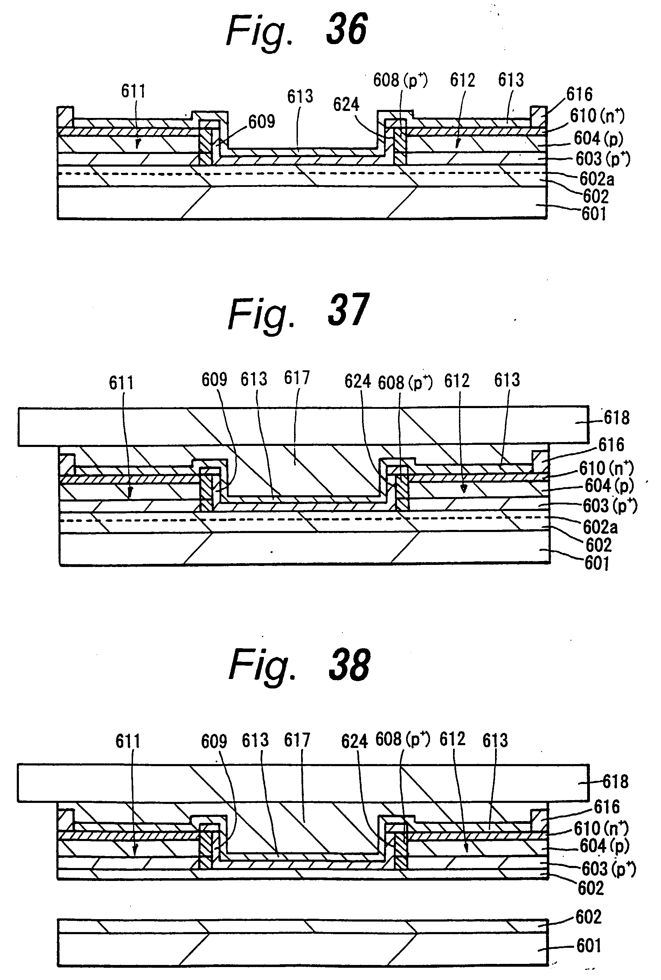

Next, as shown in Fig. 36, an anti-reflection film 613 in form of a silicon nitride film, for example, is formed on the entire surface by CVD, for example, and the anti-reflection film 613 is selectively removed by etching to expose the n⁺-type single-crystal silicon layer 610. After that, a metal film, such aluminum film, is formed on the entire surface by vacuum evaporation or CVD, for example, and then patterned into a predetermined configuration by etching to form metal electrodes 616.

Next, as shown in Fig. 37, a transparent substrate 618 made of a transparent plastic film, for example, is bonded to the surface of the thin-film single-crystal silicon solar cells 611, using an adhesive 617 preferably having a high tensile strength.

Next, in the same manner as the fourth embodiment, the single-crystal silicon substrate 610 is separated from the thin-film single-crystal silicon solar cell 611, as shown in Fig. 38. that is, an ultrasonic wave of the frequency of 25 kHz and the power of 600 W, for example, is irradiated to the single-crystal silicon substrate 601 immersed in water or ethanol solution, so that the energy of the ultrasonic wave decreases the tensile strength of the porous silicon layer 602a as the separation layer and promotes separation of the single-crystal silicon substrate 601 along the porous silicon layer 602a. Alternatively, tensile forces in opposite directions may be applied to the transparent substrate 618 and the single-crystal silicon substrate 601 to separate the single-crystal silicon substrate 601 along the porous silicon layer 602a as the separation layer. Alternatively, the single-crystal silicon substrate 601 and the transparent substrate 618 may be cooled by blowing cold nitrogen gas evaporated from liquid nitrogen, for example, to produce a shear stress caused by a difference in thermal contraction between the single-crystal silicon substrate 601 and the transparent substrate 618 and to thereby separate the single-crystal silicon substrate 601 along the porous silicon layer 602a as the separation layer. Alternatively, two or more of the above-mentioned processes may be combined to separate the single-crystal silicon substrate 601 along the porous silicon layer 602a as the separation layer.

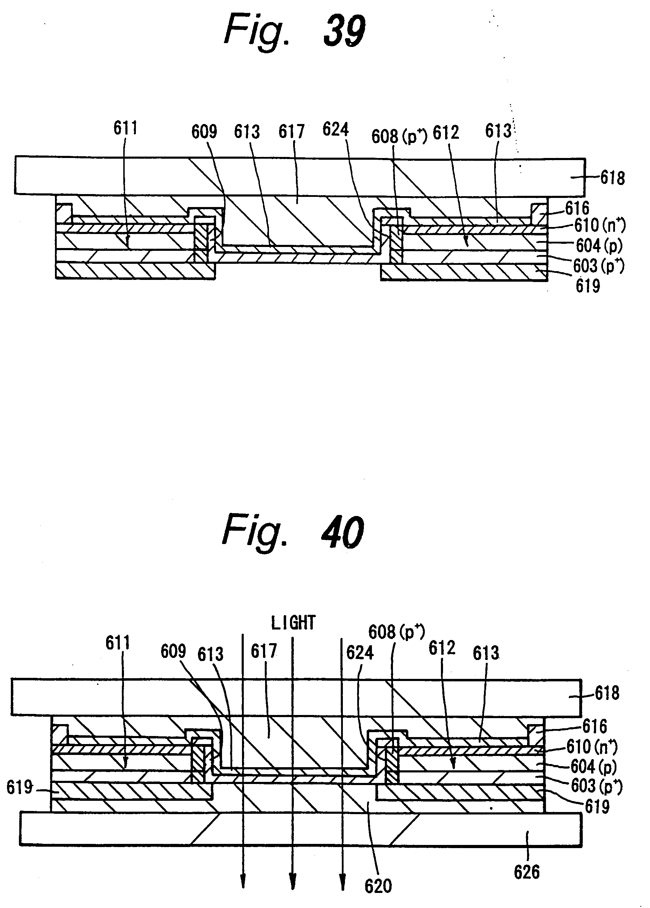

In this status, the porous silicon layer 602 remains on portions of the fine holes 624 and on back surfaces of the thin-film single-crystal silicon solar cells 611. Therefore, wet-etching is done using an alkali etchant, for example, so that no porous silicon layer remain at portions of the fine holes 624 as shown in Fig. 39.

After that, a metal film, such as aluminum film, is formed on the entire bottom surface of the thin-film single-crystal silicon solar cells 611 by vacuum evaporation or sputtering, for example, and the metal film is patterned into a predetermined configuration by etching to form metal electrodes 619 on bottom surfaces of the thin-film single-crystal silicon solar cells 611. Since the metal electrodes 619 behave also as reflective mirrors for reflecting light passing through the thin-film single-crystal silicon solar cells 611, the conversion efficiency of the thin-film single-crystal silicon solar cells, 611 can be increased.

After that, as shown in Fig. 40, a transparent substrate 626 made of a transparent plastic film, for example is bonded to bottom surfaces of the thin-film single-crystal silicon solar cells 611, using an adhesive.

As a result, see-through thin-film single-crystal silicon solar cells having a plurality of fine holes 624 permitting light to pass through are completed on the transparent substrate 618.

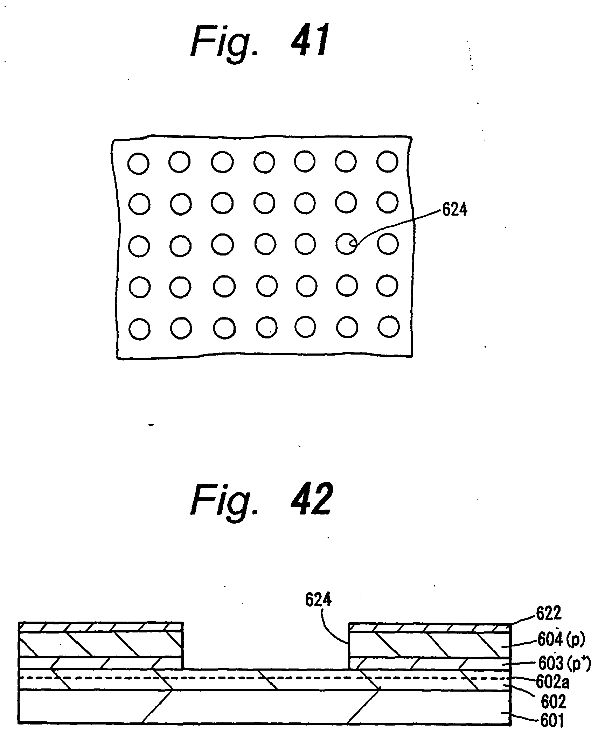

A plan-view configuration of the thin-film single-crystal silicon solar cells is shown in Fig. 41. In order to introduce external light in a natural form into a room of a house, for example, through the thin-film single-crystal silicon solar cells, the fine holes 624 must be made in a uniform distribution as shown in Fig. 41. However, if it is sufficient to obtain merely see-through thin-film single-crystal silicon solar cells, the fin holes 624 need not be distributed uniformly.

As described above, the eighth embodiment can realize see-through thin-film single-crystal silicon solar cells by making the fine holes 624 permitting beams of light to pass through. The see-through thin-film single-crystal silicon solar cells can generate a larger amount of electricity generation than conventional see-through amorphous silicon solar, cells, and can greatly increase the cost performance. Additionally, the thin-film single-crystal silicon solar cells use a thin film as the solar cell layer and uses flexible substrates as the transparent substrate 618 and the substrate 621, a high conversion efficiency and a high flexibility can be realized.

Moreover, the single-crystal silicon substrate 601 can be reused repeatedly like that explained with the fourth embodiment, and the cost of the thin-film single-crystal silicon solar cells can be decreased.

Next explained is a thin-film single-crystal silicon solar cell according to the ninth embodiment of the invention the following advantages are obtained.

In the ninth embodiment, the same steps as those of the fourth embodiment are conducted until the p-type single-crystal silicon layer 604 is formed as shown in Fig. 42. After that, a single-layer film of silicon nitride, or a compound film combining a silicon nitride film and a chrome or metal film, is formed on the p-type single-crystal silicon layer 604 by CVD, vacuum evaporation or sputtering. Then, the film is patterned into a shape defining fine holes by etching to form the mask 622. By using the mask 622, selective portions of the p-type single-crystal silicon layer 604 and the p⁺-type single-crystal silicon layer 603 not covered by the mask 622 are changed to a porous layer by anodic oxidation. Subsequently, the porous silicon layer is removed by wet etching using Noah solution, for example to form fine holes 624. The porous silicon layer can be readily removed by wet etching using Noah solution.

After that, the process is progressed in the same manner as the fourth embodiment, and intended thin-film single-crystal silicon solar cells are completed.

Also the ninth embodiment attains the same advantages as those of the seventh embodiment.

Next explained is a thin-film single-crystal silicon solar cell according to the tenth embodiment of the invention.

In the tenth embodiment, after the same steps as those of the fourth embodiment are executed until the p-type single-crystal silicon layer 604 is formed as shown in Fig. 42, a single-layer film of silicon nitride, or a compound film combining a silicon nitride film and a chrome or metal film, is formed on the p-type single-crystal silicon layer 604 by CVD, vacuum evaporation or sputtering. Then, the film is patterned into a shape defining fine holes by etching to form the mask 622. By using the mask 622, selective portions of the p-type single-crystal silicon layer 604 and the p⁺-type single-crystal silicon layer 603 not covered by the mask 622 are changed to a porous layer by anodic oxidation. Additionally, the porous silicon layer is oxidized to form a silicon oxide layer (not shown) and thereby to form fine holes 624. In this case, the silicon nitride film forming the mask 622 is used as the mask for oxidization.

After that, the process is progressed in the same manner as the fourth embodiment, and intended thin-film single-crystal silicon solar cells are completed.

Also the tenth embodiment attains the same advantages as those of the eighth embodiment.

Although the invention has been described by way of various embodiments, the invention is not limited to these specific examples, but involves various changes and modifications based on the spirit of the invention.

For example, glass substrates, for example, may be used as the transparent substrates 618, 626 and substrate 21 used in the fourth to tenth embodiments, if appropriate. Similarly, transparent electrodes made of ITO, for example, may be used instead of metal electrodes 616, 619, if appropriate.

Although the fourth embodiment uses an alkali etchant, such as KOH, in wet etching for isolating the solar cell layers 606, 607 made of the p⁺-type single-crystal silicon layer 603 and the p-type single-crystal silicon layer 604, an acid may be used for the wet etching, if appropriate. Also in the eighth embodiment, an acid may be used in lieu of an alkali etchant in wet etching for making fine holes 624 in the solar cell layer 606 comprising the p⁺-type single-crystal silicon layer 603 and the p-type single-crystal silicon layer 604.

Still in the eighth embodiment, although the p⁺-type single-crystal silicon layer 625 is formed in the inner wall portion of each fine hole 624, the p⁺-type single-crystal silicon layer 625 may be omitted when the silicon oxide layer 609, for example, formed in the inner wall portion of the fine hole 624 can reduce the speed of recombination along the surface.

Further, the thin-film single-crystal silicon solar cells according to the fourth embodiment can be made as a see-through solar cell module by making fine holes in individual thin-film single-crystal silicon solar cells in the same manner as the eighth embodiment.

As explained above, the method for manufacturing thin-film semiconductor device according to the invention makes it easy to separate the thin-film semiconductor device from a first substrate and to manufacture a high-quality thin-film semiconductor device without the problem of unintentional separation during formation of the semiconductor device, because a shear stress is produced in a separation layer in the porous layer by cooling the product after bonding a second substrate onto the thin-film semiconductor device, so that the thin-film semiconductor device is separated from the first substrate together with the second substrate along the separation layer and results in being transferred to the second substrate. Especially, the method is effective when fabricating a thin-film semiconductor device having a large area. Additionally, by combining irradiation of an ultrasonic wave and/or application of a tensile stress with the cooling process, the method can separate thin-film semiconductor devices a second substrate is bonded to the thin-film semiconductor devices with a high yield without damages to the products.

Also another method according to the invention, configured to irradiate an ultrasonic wave to decrease the tensile strength of the separation layer in the porous layer, can readily separate thin-film semiconductor devices from the first substrate, and can fabricate high-quality thin-film semiconductor devices without the problem of unintentional separation during formation of the semiconductor devices. Here again, the method is especially effective when fabricating a thin-film semiconductor device extending over a wide area.

Also another method for manufacturing a thin-film semiconductor device according to the invention, configured to apply a centrifugal force to decrease the tensile strength of the separation layer in the porous layer, can separate thin-film semiconductor devices from the first substrate, easily and quickly, and can therefore fabricate high-quality thin-film semiconductor devices in a short time. Here again, the method is especially effective when manufacturing a thin-film semiconductor device extending over a wide area.

The apparatus for manufacturing thin-film semiconductor devices according to the invention, using anti-warpage means to prevent warpage of substrates upon cooling the first and second substrates, can reliably prevent unintentional separation of thin-film semiconductor devices, and can fabricate high-quality thin-film semiconductor devices.

Another apparatus for manufacturing thin-film semiconductor devices according to the invention, including a hold portion for holding thin-film semiconductor devices having bonded the second substrate and a damping portion confronting the hold portion in the transfer holder, can apply a centrifugal force without damages to thin-film semiconductor devices separated by the centrifugal force, and can fabricate high-quality thin-film semiconductor devices.

The thin-film semiconductor device according to the invention has a high quality and can be made as a device extending over a wide area, because it is transferred from the first substrate to the second substrate by utilizing a shear stress produced in the porous layer formed in the first substrate due to a difference in contraction coefficient between these substrates when cooled by cooling means.

Also another thin-film semiconductor device according to the invention has a high quality and can be made as a device extending over a wide area because it is transferred from the first substrate to the second substrate, utilizing a stress produced in the porous layer caused by an ultrasonic wave after it is formed on the porous layer on the first substrate.

Also another thin-film semiconductor device according to the invention has a high quality and can be made as a device extending over a wide area because it is transferred to the second substrate, utilizing a stress produced in the porous layer due to a centrifugal force after it is made on the porous layer on the first substrate.

Thus, the invention can provide a monolithic thin-film single-crystal semiconductor solar cell and its manufacturing method, which realize cost reduction, flexibility, miniaturization, flexibility in design choice of appliances having mounted solar cells, and extension over a wide area.

Additionally, the invention can provide a see-through thin-film single-crystal semiconductor solar cell having a high conversion efficiency, and its manufacturing method.

## Claims

1. A method for manufacturing a thin-film semiconductor device configured to form the thin-film semiconductor device on a first substrate and thereafter transfer the thin-film semiconductor device from the first substrate to a second substrate, comprising the steps of:
forming a porous layer containing a separation layer on said first substrate;
forming said thin-film semiconductor device on said porous layer; and
after bonding said second substrate different from said first substrate in contraction coefficient by cooling onto said thin-film semiconductor device, cooling the product by cooling means to produce a shear stress in said separation layer in said porous layer and to separate said thin-film semiconductor device from said first substrate along said separation layer.

2. The method for manufacturing a thin-film semiconductor device according to claim 1 wherein the cooling is done by blowing vapor of liquid nitrogen or liquid helium, or dry ice, onto said first substrate, said thin-film semiconductor device and said second substrate, or by immersing at least one of said first substrate, said thin-film semiconductor device and said second substrate.

3. The method for manufacturing a thin-film semiconductor device according to claim 1 wherein the separation of said thin-film semiconductor device from the first substrate is done by combining with the cooling by the cooling means at least one of a process of irradiating an ultrasonic wave to said first substrate and said second substrate and a process of applying a centrifugal force between said fist substrate and said second substrate.

4. A method for manufacturing a thin-film semiconductor device configured to first form the thin-film semiconductor device on a first substrate and thereafter transfer the thin-film semiconductor device from the first substrate to a second substrate, comprising the steps of:
forming a porous layer containing a separation layer on said first substrate;
forming said thin-film semiconductor device on said porous layer; and
after bonding said second substrate onto said thin-film semiconductor device, irradiating an ultrasonic wave to separate said thin-film semiconductor device from said first substrate along said separation layer.

5. The method for manufacturing a thin-film semiconductor device according to claim 4 wherein the irradiation of an ultrasonic wave is done by immersing in a solution said thin-film semiconductor device formed on said first substrate and having bonded with said second substrate.

6. The method for manufacturing a thin-film semiconductor device according to claim 4 wherein a tensile stress is applied after the tensile strength of said separation layer in said porous layer is decreased by the irradiation of an ultrasonic wave, to thereby separate said thin-film semiconductor device from said first substrate.

7. The method for manufacturing a thin-film semiconductor device according to claim 6 wherein the irradiation of an ultrasonic wave and application of a tensile stress are repeated to separate said thin-film semiconductor device from said first substrate.

8. A method for manufacturing a thin-film semiconductor device configured to first form the thin-film semiconductor device on a first substrate and thereafter transfer the thin-film semiconductor device from the first substrate to a second substrate, comprising the steps of:
forming a porous layer containing a separation layer on said first substrate;
forming said thin-film semiconductor device on said porous layer; and
after bonding said second substrate onto said thin-film semiconductor device, applying a centrifugal force to separate said thin-film semiconductor device from said first substrate along said separation layer.

9. The method for manufacturing a thin-film semiconductor device according to claim 8 wherein said centrifugal force is adjusted by attaching a weight to said second substrate after said second substrate is bonded onto said thin-film semiconductor device.

10. The method for manufacturing a thin-film semiconductor device according to claim 1 wherein said first substrate is a single-crystal or polycrystalline semiconductor substrate, and is prepared for re-use in a later transfer process by removing any remaining portion of said porous layer after said thin-film semiconductor device is separated from said semiconductor substrate.

11. The method for manufacturing a thin-film semiconductor device according to claim 1 wherein said porous layer is made by anodic oxidation, and the tensile strength of said separation layer in said porous layer is adjusted by adjusting the density current for anodic oxidation or the time of anodic oxidation.

12. The method for manufacturing a thin-film semiconductor device according to claim 1 wherein said thin-film semiconductor device is formed in one of a single-crystal layer, polycrystalline layer or an amorphous layer, or in a compound film of said layers.

13. The method for manufacturing a thin-film semiconductor device according to claim 1 wherein said thin-film semiconductor device is one of a photo detector device containing a solar cell, a light emitting device, an integrated circuit, or a liquid crystal display device.

14. The method for manufacturing a thin-film semiconductor device according to claim 1 wherein said second substrate is a glass plate, a plastic plate, a metal plate or a semiconductor substrate.

15. An apparatus for manufacturing a thin-film semiconductor device configured to transfer the thin-film semiconductor device formed on a first substrate onto a second substrate different from said second substrate in contraction coefficient by cooling, comprising:
a cooling tank including a hold portion for holding the thin-film semiconductor device formed on said first substrate and having bonded said second substrate, and a cooling means for cooling the first substrate and second substrate of said thin-film semiconductor device held by said hold portion; and
anti-warpage means for preventing warpage of the first substrate and the second substrate caused by cooling these substrates.

16. The apparatus for manufacturing a thin-film semiconductor device according to claim 15 wherein said anti-warpage means is at least one of a binding member for tightly binding the second substrate and the hold portion after the thin-film semiconductor device sandwiched between the first substrate and the second substrate is held by the hold portion within the cooling tank and a weight put on the second substrate.

17. The apparatus for manufacturing a thin-film semiconductor device according to claim 15 wherein said thin-film semiconductor device is formed on a porous layer previously formed on said first substrate and containing therein a separation layer having a weak separation strength.

18. An apparatus for manufacturing a thin-film semiconductor device configured to transfer the thin-film semiconductor device formed on a first substrate onto a second substrate different from said second substrate in contraction coefficient by cooling, comprising:
a transfer holder including a hold portion for grasping one of the first substrate and the second substrate of the thin-film semiconductor device formed on said the first substrate and having bonded the second substrate, and a damping portion confronting the hold portion; and
centrifugal force applying means for applying a centrifugal force to the transfer holder in a direction from hold portion toward the damping portion.

19. The apparatus for manufacturing a thin-film semiconductor device according to claim 18 wherein said centrifugal force applying means includes a rotary shaft rotated by a drive motor, and a rotary body coupled to said rotary shaft and capable of containing at least one said transfer holder.

20. The apparatus for manufacturing a thin-film semiconductor device according to claim 19 wherein said rotary body can contain a plurality of said transfer holders and balancers between respective adjacent said transfer holders.

21. The apparatus for manufacturing a thin-film semiconductor device according to claim 18 wherein said thin-film semiconductor device is formed on a porous layer previously formed on said first substrate and containing therein a separation layer having a weak tensile force.

22. A thin-film semiconductor device manufactured by first being formed on a first substrate and thereafter being transferred to a second substrate, characterized in being formed on a porous layer made on said first substrate, and thereafter being transferred from said first substrate onto said second substrate different from said first substrate in contraction coefficient by cooling by utilizing a stress produced in said porous layer when cooled by cooling means.

23. A thin-film semiconductor device manufactured by first being formed on a first substrate and thereafter being transferred to a second substrate, characterized in being formed on a porous layer made on said first substrate, and thereafter being transferred from said first substrate onto said second substrate by utilizing a stress produced in said porous layer due to an ultrasonic wave.

24. A thin-film semiconductor device manufactured by first being formed on a first substrate and thereafter being transferred to a second substrate, characterized in being formed on a porous layer made on said first substrate, and thereafter being transferred from said first substrate onto said second substrate by utilizing a stress produced in said porous layer due to a centrifugal force.

25. A thin-film single-crystal semiconductor solar cell comprising:
a substrate; and
a plurality of elemental thin-film single-crystal semiconductor solar ells formed on said substrate in an isolated relationship.

26. The thin-film single-crystal semiconductor solar cell according to claim 25 wherein said thin-film single-crystal semiconductor solar cells include at least a single-crystal semiconductor layer having a high impurity concentration and a single-crystal semiconductor layer having a low impurity concentration.

27. The thin-film single-crystal semiconductor solar cell according to claim 25 wherein metal electrodes are provided on one surface of said thin-film single-crystal semiconductor solar cells opposite from said substrate.

28. The thin-film single-crystal semiconductor solar cell according to claim 25 wherein a material having a strength against bending fills spaces between said thin-film single-crystal semiconductor solar cells.

29. The thin-film single-crystal semiconductor solar cell according to claim 25 wherein said thin-film single-crystal semiconductor solar cells are bonded onto said substrate.

30. The thin-film single-crystal semiconductor solar cell according to claim 25 wherein said substrate is made of an insulator.

31. The thin-film single-crystal semiconductor solar cell according to claim 25 wherein said substrate is made of plastic or glass.

32. The thin-film single-crystal semiconductor solar cell according to claim 25 wherein said thin-film single-crystal semiconductor solar cells are made of single-crystal silicon.

33. A method for manufacturing a thin-film single-crystal semiconductor solar cell comprising the steps of:
forming a porous layer on a semiconductor substrate;
forming a solar cell layer on said porous layer;
separating said solar cell layer into plural regions; and
separating said solar cell layer from said semiconductor substrate and transferring it to another substrate.

34. The method for manufacturing a thin-film single-crystal semiconductor solar cell according to claim 33 wherein said solar cell layer is separated into plural regions by removing selective regions of said solar cell layer behaving as separation regions by etching.

35. The method for manufacturing a thin-film single-crystal semiconductor solar cell according to claim 33 wherein said solar cell layer is separated into plural regions by changing selective regions of said solar cell layer to be used as separation regions into a porous status and by removing the porous layer by etching.

36. The method for manufacturing a thin-film single-crystal semiconductor solar cell according to claim 33 wherein said solar cell layer is separated into plural regions by changing selective regions of said solar cell layer to be used as separation layers into a porous status, and by oxidizing the porous layer into an oxide film.

37. The method for manufacturing a thin-film single-crystal semiconductor solar cell according to claim 33 wherein said solar cell layer is separated into plural regions by conducting anodic oxidation to form said porous layer.

38. The method for manufacturing a thin-film single-crystal semiconductor solar cell according to claim 33 wherein said solar cell layer includes at least a single-crystal semiconductor layer having a high impurity concentration and a single-crystal semiconductor layer having a low impurity concentration.

39. The method for manufacturing a thin-film single-crystal semiconductor solar cell according to claim 33 wherein said solar cell layer is separated from said semiconductor substrate by irradiating an ultrasonic wave onto semiconductor substrate after said another substrate is bonded to the surface of said solar cell layer, and/or, applying opposite tensile forces to said semiconductor substrate and said another substrate, and/or, cooling said semiconductor substrate and said another substrate.

40. The method for manufacturing a thin-film single-crystal semiconductor solar cell according to claim 33 wherein said another substrate is made of an insulator.

41. The method for manufacturing a thin-film single-crystal semiconductor solar cell according to claim 33 wherein said another substrate is made of plastic or glass.

42. The method for manufacturing a thin-film single-crystal semiconductor solar cell according to claim 33 further comprising the step of removing said porous layer remaining on bottom surface of said solar cell layer by etching after said solar cell layer is transferred to said another substrate, and forming metal electrodes on exposed portions of the back surface of said solar cell layer.

43. The method for manufacturing a thin-film single-crystal semiconductor solar cell according to claim 33 further comprising the step of filling spaces between the separated regions of said solar cell layer with aa material having a strength against bending.

44. The method for manufacturing a thin-film single-crystal semiconductor solar cell according to claim 33 wherein said solar cell layer is made of single-crystal silicon.

45. A thin-film single-crystal semiconductor solar cell comprising:
a transparent substrate; and
a thin-film single-crystal semiconductor solar cell formed on said transparent substrate, said thin-film single-crystal semiconductor solar cell having fine holes permitting a plurality of beams of light to pass through.

46. The thin-film single-crystal semiconductor solar cell according to claim 45 wherein said thin-film single-crystal semiconductor solar cell includes at least a single-crystal semiconductor layer having a high impurity concentration and a single-crystal semiconductor layer having a low impurity concentration.

47. The thin-film single-crystal semiconductor solar cell according to claim 45 wherein a metal electrode is provided on one surface of said thin-film single-crystal semiconductor solar cell opposite from said transparent substrate.

48. The thin-film single-crystal semiconductor solar cell according to claim 45 wherein said thin-film single-crystal semiconductor solar cell is bonded onto said transparent substrate.

49. The thin-film single-crystal semiconductor solar cell according to claim 45 wherein said transparent substrate is made of an insulator.

50. The thin-film single-crystal semiconductor solar cell according to claim 45 wherein said transparent substrate is made of plastic or glass.

51. The thin-film single-crystal semiconductor solar cell according to claim 45 wherein said thin-film single-crystal semiconductor solar cell is made of single-crystal silicon.

52. A method for manufacturing a thin-film single-crystal semiconductor solar cell, comprising the steps of:
forming a porous layer on a semiconductor substrate;
forming a solar cell layer on said porous layer;
forming fine holes in said solar cell layer, which permit a plurality of beams of light to pass through; and
separating said solar cell layer from said semiconductor substrate and transferring it another transparent electrode.

53. The method for manufacturing a thin-film single-crystal semiconductor solar cell according to claim 52 wherein said fine holes are made by removing selective portions of said solar cell layer by etching.

54. The method for manufacturing a thin-film single-crystal semiconductor solar cell according to claim 52 wherein said fine holes are made by changing selective portions of said solar cell into a porous status and by removing the porous layer.

55. The method for manufacturing a thin-film single-crystal semiconductor solar cell according to claim 52 wherein said fine holes are made by changing selective portions of said solar cell layer and by oxidizing the porous layer.

56. The method for manufacturing a thin-film single-crystal semiconductor solar cell according to claim 52 wherein said porous layer is made by anodic oxidation of said semiconductor substrate.

57. The method for manufacturing a thin-film single-crystal semiconductor solar cell according to claim 52 wherein said solar cell layer includes at least a single-crystal semiconductor layer having a high impurity concentration and a single-crystal semiconductor layer having a low impurity concentration.

58. The method for manufacturing a thin-film single-crystal semiconductor solar cell according to claim 52 wherein said solar cell layer is separated from said semiconductor substrate by irradiating an ultrasonic wave onto semiconductor substrate after said another transparent substrate is bonded to the surface of said solar cell layer, and/or, applying opposite tensile forces to said semiconductor substrate and said another transparent substrate, and/or, cooling said semiconductor substrate and said another transparent substrate.

59. The method for manufacturing a thin-film single-crystal semiconductor solar cell according to claim 52 wherein said another transparent substrate is made of an insulator.

60. The method for manufacturing a thin-film single-crystal semiconductor solar cell according to claim 52 wherein said another transparent substrate is made of plastic or glass.

61. The method for manufacturing a thin-film single-crystal semiconductor solar cell according to claim 52 further comprising the step of removing said porous layer remaining on bottom surface of said solar cell layer by etching after said solar cell layer is transferred to said another transparent substrate, and forming a metal electrode on the exposed portion of the bottom surface of said solar cell layer.

62. The method for manufacturing a thin-film single-crystal semiconductor solar cell according to claim 52 wherein said solar cell layer is made of single-crystal silicon.
